(19) Europäisches Patentamt
European Patent Office
Office européen des brevets

(11) **EP 2 656 153 B1**

(12) **EUROPÄISCHE PATENTSCHRIFT**

(45) Veröffentlichungstag und Bekanntmachung des Hinweises auf die Patenterteilung:
**29.07.2020  Patentblatt 2020/31**

(21) Anmeldenummer: **11805773.6**

(22) Anmeldetag: **15.12.2011**

(51) Int Cl.:
**G05B 5/01** (2006.01)

(86) Internationale Anmeldenummer:
**PCT/EP2011/006356**

(87) Internationale Veröffentlichungsnummer:
**WO 2012/084153 (28.06.2012 Gazette 2012/26)**

(54) **DREHRATENSENSOR UND VERFAHREN ZUR RÜCKSTELLUNG EINES MIT EINER HARMONISCHEN SCHWINGUNG ANGEREGTEN SCHWINGERS**

YAW RATE SENSOR AND METHODS FOR RESETTING AN OSCILLATOR EXCITED BY A HARMONIC OSCILLATION

CAPTEUR DE VITESSE DE ROTATION ET PROCÉDÉS SERVANT À REPOSITIONNER UN OSCILLATEUR EXCITÉ AVEC UNE OSCILLATION HARMONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2010  DE 102010055631**

(43) Veröffentlichungstag der Anmeldung:
**30.10.2013  Patentblatt 2013/44**

(73) Patentinhaber: **Northrop Grumman LITEF GmbH 79115 Freiburg (DE)**

(72) Erfinder:
• SPAHLINGER, Günter
  70188 Stuttgart (DE)
• RUF, Markus
  79183 Waldkirch (DE)

(74) Vertreter: **Müller Hoffmann & Partner Patentanwälte mbB St.-Martin-Strasse 58 81541 München (DE)**

(56) Entgegenhaltungen:
WO-A1-93/15447          DE-A1-102005 005 248
DE-A1-102008 044 000

**Beschreibung**

Die Erfindung bezieht sich auf eine Reglereinheit zur Rückstellung einer Auslenkung eines mit einer harmonischen Schwingung angeregten Schwingers, eine Vorrichtung umfassend eine solche Reglereinheit, in der Form eines Drehratensensors, sowie Verfahren zum Betrieb und zur Herstellung einer solchen Reglereinheit.

Übliche Regelungsmethodiken sind auf Regelungsprobleme mit konstanter oder sich nur langsam ändernder Führungsgröße zugeschnitten, wobei der Wert einer von einer Störgröße beeinflussten Regelgröße möglichst nahe bei einem vorgegebenen Sollwert gehalten wird, bzw. möglichst nahe einem sich ändernden Sollwert nachgeführt wird. Manche Anwendungen, zum Beispiel mikromechanische Drehratensensoren zur Auswertung einer Corioliskraft, sehen die Rückstellung einer Auslenkung eines im stationären Fall mit seiner Resonanzfrequenz schwingenden Schwingers durch einen Regelkreis vor. Ein Regler für einen solchen Regelkreis mit einer harmonischen Schwingung als Führungsgröße wird üblicherweise so ausgelegt, dass ein den Schwinger anregendes harmonisches Kraftsignal F derart kompensiert wird, dass der Schwinger - abgesehen von der harmonischen Schwingung entsprechend der Führungsgröße - möglichst keine Bewegung ausführt.

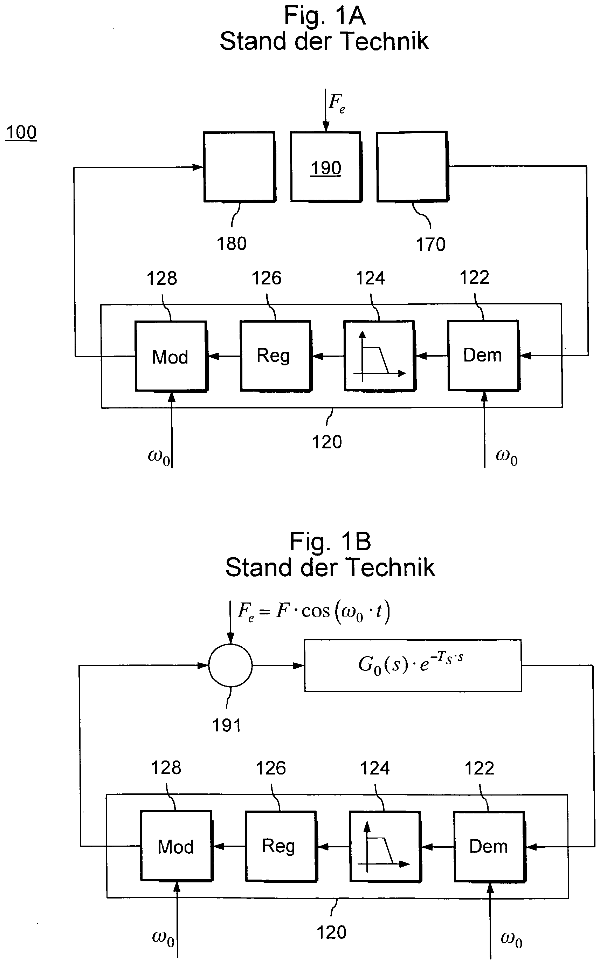

Typischerweise wird diese Regelungsaufgabe mit dem in den Figuren 1A bis 1D gezeigten Ansatz gelöst. Die Figur 1A bezieht sich auf eine Vorrichtung 100 mit einer Regelstrecke, zum Beispiel einem mechanischen Schwinger 190, dessen translatorische oder rotatorische Auslenkung durch einen Sensor 170 erfasst wird. Der Schwinger 190 ist derart gelagert bzw. aufgehängt, dass er entlang einer Anregungsrichtung beweglich ist und mit einer Resonanzkreisfrequenz $\omega_0$ zu schwingen vermag. Entlang der Anregungsrichtung wirkt auf den Schwinger 190 ein harmonisches Kraftsignal $F_e$. Ein vom Sensor 170 ausgegebenes Messsignal bildet die Bewegung des Schwingers 190 entlang der Anregungsrichtung ab. Die Bewegung des Schwingers 190 umfasst eine durch eine Kraftamplitude F (Störsignal) modulierte Resonanzschwingung mit der Resonanzkreisfrequenz $\omega_0$ des Schwingers 190.

Das Messsignal (Systemausgangssignal) wird einer Reglereinheit 120 mit einem Demodulator 122 zugeführt. Im Demodulator 122 wird das Systemausgangssignal mit einem harmonischen Signal einer Frequenz $\omega_0$ gleich der Resonanzkreisfrequenz $\omega_0$ des Schwingers 190 multipliziert, wobei eine Basisbandversion des Systemausgangssignals sowie weitere Mischprodukte gebildet werden. Ein Tiefpassfilter 124 dämpft die höheren Frequenzanteile, insbesondere bei der doppelten Resonanzkreisfrequenz $2 \cdot \omega_0$ des Schwingers 190. Das Basisbandsignal wird dem Regler 126 zugeführt, der im Basisband arbeitet und zu dessen Entwurf und Dimensionierung gängige Reglerentwurfsmethoden zum Einsatz kommen können. Der Regler 126 ist beispielsweise ein kontinuierlicher PI-Regler, mit dem sich aufgrund seines Integralanteils im Fall einer konstanten Führungsgröße hohe stationäre Genauigkeit erzielen lässt.

Das Ausgangssignal des Reglers 126 wird in einem Modulator 128 mit einem harmonischen Signal mit der Frequenz $\omega_0$ gleich der Resonanzkreisfrequenz $\omega_0$ des Schwingers 190 multipliziert (moduliert). Das Modulationsprodukt wird als Reglersignal einem Aktuator 180 zugeführt, der anhand des Reglersignals eine Kraft auf den Schwinger 190 ausübt, die der Auslenkung des Schwingers 190 entgegenwirkt. Mit der Resonanzkreisfrequenz $\omega_0$ und Dämpfung $s_0$ des Schwingers sowie der Verstärkung A und der Streckentotzeit $T_s$ des aus Aktuator 180, Schwinger 190 und Sensor 170 gebildeten Systems lässt sich die Übertragungsfunktion des zu regelnden Schwingers 190 mit der Gleichung (1) darstellen:

$$(1) \qquad G(s) \; = \; \frac{A}{(s + s_o)^2 + \omega_0{}^2} \cdot e^{-T_s \cdot s} = G_o(s) \cdot e^{-T_s \cdot s}$$

Im Folgenden wird angenommen, dass die Dämpfung $s_0$ des Schwingers 190 sehr viel kleiner ist als seine Resonanzkreisfrequenz, $s_0 << \omega_0$ und dass der Schwinger 190 insgesamt mit dem harmonischen Kraftsignal $F_e$ angeregt wird, bei dem eine Kraftamplitude F eine Anregungsschwingung mit der Resonanzkreisfrequenz $\omega_0$ des Schwingers überlagert, bzw. amplitudenmoduliert:

$$(2) \qquad F_e = F \cdot \cos(\omega_0 \cdot T)$$

Entsprechend der Figur 1B lassen sich dann Aktuator 180, Schwinger 190 und Sensor 170 der Figur 1A als System mit einem Summationspunkt 191 und einer Übertragungsfunktion G(s) darstellen, wobei am Summationspunkt 191 ein von der Reglereinheit 120 erzeugtes Reglersignal zu dem harmonischen Kraftsignal $F_e$ addiert wird und auf das Summensignal die Übertragungsfunktion G(s) gemäß Gleichung (1) wirkt.

Das Tiefpassfilter 124, das bereits bei der doppelten Resonanzkreisfrequenz des Schwingers eine ausreichende Dämpfung aufweisen soll, um das Mischprodukt bei $2 \cdot \omega_0$ ausreichend zu dämpfen, begrenzt die Bandbreite des Reglers und damit dessen Reaktionsgeschwindigkeit auf Änderungen der Kraftamplitude F.

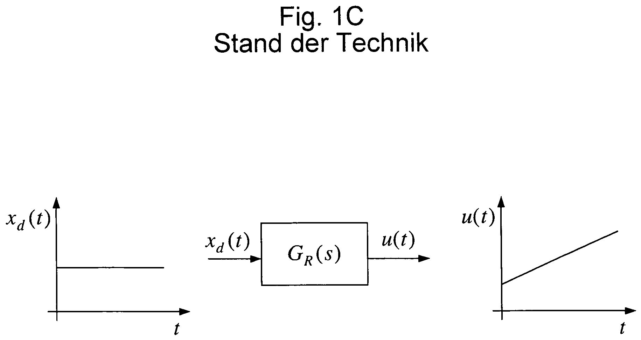

Die Figur 1C zeigt schematisch das Ausgangssignal u(t) am Ausgang eines kontinuierlichen PI-Reglers mit einer Übertragungsfunktion $G_R(s)$. Ein konstantes Eingangssignal $x_d(t)$ am Reglereingang erzeugt einen zeitproportionalen Verlauf $u(t)$ am Reglerausgang.

Für einen kontinuierlichen PI-Reglers mit dem Verstärkungsfaktor $K_P$ und dem Integrierbeiwert $K$, ergibt sich für ein Sprungsignal $\sigma(t)$ als Eingangssignal die Sprungantwort $u(t)$ nach Gleichung (3):

$$(3) \qquad u(t) = (K_P + K_I \cdot t) \cdot \sigma(t).$$

Durch L-Transformation von $\sigma(t)$ und der Gleichung (3) ergibt sich die Übertragungsfunktion $G_R(s)$ nach Gleichung (4):

$$(4) \qquad G_R(s) = \frac{U(s)}{X_d(s)} = s \cdot (K_P \cdot \frac{1}{s} + K_I \cdot \frac{1}{s^2}) = K_P \cdot \frac{s + \dfrac{K_I}{K_P}}{s}$$

Charakteristisch für den kontinuierlichen PI-Regler ist ein aus dem Integralanteil resultierender Pol bei $s = 0$. Wird ein PI-Regler in Verbindung mit einer Regelstrecke erster Ordnung mit einer Streckenfunktion $G_S(s)$, mit dem Streckenparameter $K_S$ und der Grenzkreisfrequenz $\omega_1$ nach Gleichung (5) eingesetzt,

$$(5) \qquad G_S(s) = K_S \cdot \frac{1}{s + \omega_1}$$

so werden die Reglerparameter Verstärkungsfaktor $K_P$ und Integrierbeiwert $K_I$ üblicherweise so gewählt, dass der Pol in der Streckenfunktion $G_S(s)$ (Streckenpol) durch die Nullstelle der Übertragungsfunktion des Reglers $G_R(s)$ (Reglernullstelle) kompensiert wird. Durch Koeffizientenvergleich in den Gleichungen (4) und (5) ergibt sich als Bedingung für die Reglerparameter der Zusammenhang nach Gleichung (6):

$$(6)$$

$$\omega_1 = \frac{K_I}{K_P}$$

Gleichung (6) legt nur das Verhältnis von Verstärkungsfaktor $K_P$ zu Integrierbeiwert $K_I$ fest. Das Produkt von Streckenübertragungsfunktion $G_S(s)$ und Reglerübertragungsfunktion $G_R(s)$ ergibt die Übertragungsfunktion des korrigierten offenen Kreises $G_k(s)$. Indem sich der Streckenpol nach Gleichung (5) und die Reglernullstelle nach Gleichung (4) wegkürzen, ergibt sich für die Übertragungsfunktion des korrigierten offenen Kreises $G_k(s)$ der Zusammenhang nach Gleichung (7).

$$(7) \qquad G_k(s) = G_S(s) \cdot G_R(s) = K_S \cdot K_P \cdot \frac{1}{s}$$

Aus dem Frequenzgang des korrigierten offenen Kreises lässt sich über das Nyquist-Kriterium auf die Stabilitätseigenschaften des geschlossenen Kreises schließen. Aufgrund des Integralverhaltens des korrigierten offenen Kreises ergibt sich eine Betragskennlinie, die mit 20 db/Dekade abfällt. Die Phase beträgt für positive Frequenzen, auf die die Anwendung des Nyquist-Kriteriums üblicherweise beschränkt bleibt, immer -90°. Die Phasenkennlinie ist eine ungerade Funktion und weist bei der Frequenz 0 einen 180°-Sprung von +90° für negative Frequenzen nach -90° für positive Frequenzen auf. Die Übertragungsfunktion $G_w(s)$ für den geschlossenen Kreis ergibt sich aus der des korrigierten offenen Kreises $G_k(s)$ allgemein nach Gleichung (8):

$$(8) \qquad G_w(s) = \frac{G_k(s)}{1 + G_k(s)}$$

Aus Gleichung (8) ergibt sich, dass die Übertragungsfunktion $G_w(s)$ für den geschlossenen Kreis nur dann stabil ist, wenn die Ortskurve des korrigierten offenen Kreises für $0 \leq \omega < \infty$ den Punkt -1 weder umschließt noch durchdringt. Eine dazu gleichwertige Bedingung ist, dass beim Durchgang der Betragskennlinie des korrigierten offenen Kreises durch die 0 dB Linie die Phase des korrigierten offenen Kreises größer -180° ist. Da im obigen Fall die Phase konstant -90° beträgt, ist demnach der geschlossene Kreis unabhängig von der Wahl des Verstärkungsfaktors $K_P$ immer stabil.

Aus der Frequenz beim Durchgang der Betragskennlinie durch die 0 dB Linie lässt sich auf die Bandbreite des geschlossenen Kreises schließen. Über den Verstärkungsfaktor $K_P$ lässt sich der Betragsfrequenzgang in Ordinatenrichtung verschieben und damit der Durchgang durch die 0 dB Linie bzw. die daraus resultierende Bandbreite beeinflussen.

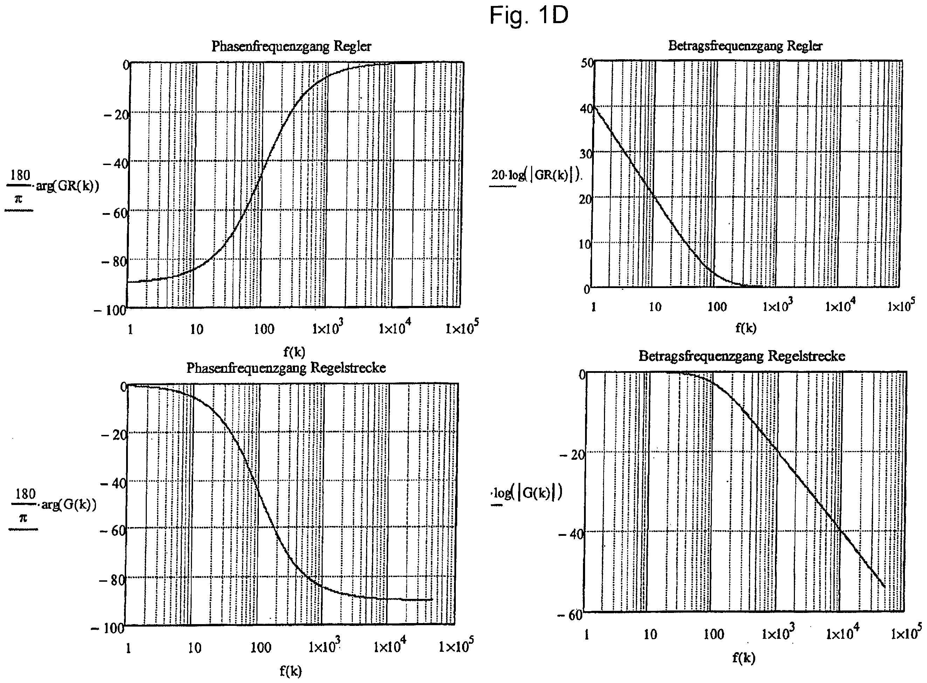

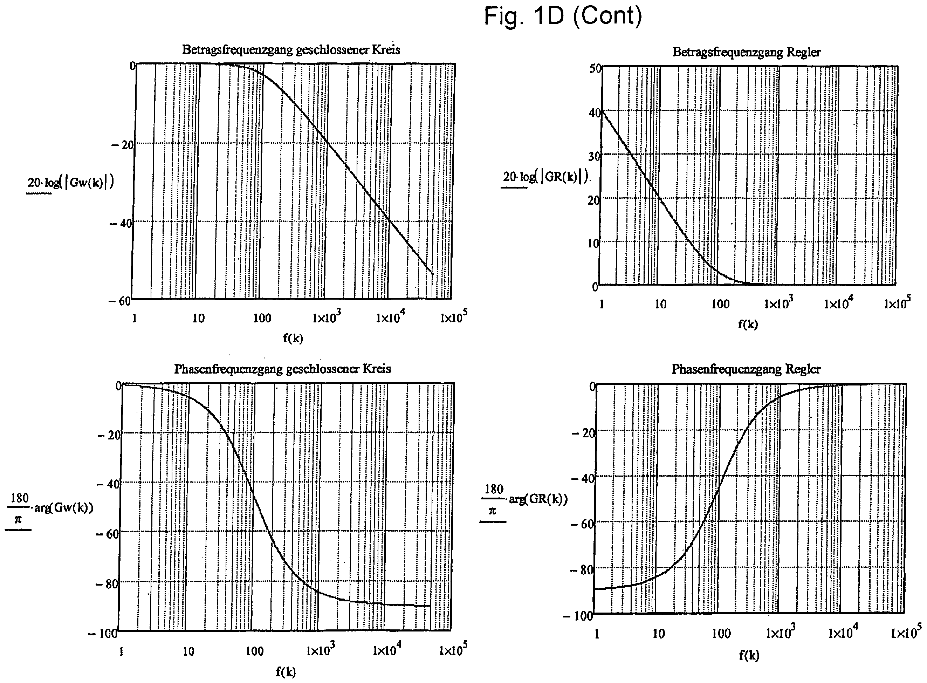

Die Figur 1D zeigt für ein Beispiel mit einer Regelstrecke erster Ordnung mit der Grenzkreisfrequenz $\omega_1 = 2 \cdot \pi \cdot 100$ Hz, einem Streckenparameter $K_S = \omega$, und mit einem PI-Regler, dessen Reglernullstelle so gewählt ist, dass sie den Streckenpol kompensiert, und dessen Verstärkungsfaktor $K_P = 1$ ist, in der linken Spalte von oben nach unten die Betragsfrequenzgänge von Regelstrecke, Regler, korrigiertem offenen Kreis und geschlossenem Kreis und in der rechten Spalte von oben nach unten die Phasenfrequenzgänge von Regelstrecke, Regler, korrigiertem offenen Kreis und geschlossenem Kreis. Wie an dem Diagramm links unten zu erkennen ist, beträgt die Bandbreite des geschlossenen Kreises definiert durch die Frequenz, bei der der Betragsfrequenzgang des geschlossenen Kreises um 3 dB abgefallen ist, etwa 100 Hz.

Der Einsatz des klassischen PI-Reglers setzt eine vergleichsweise konstante Führungsgröße voraus, weshalb Anwendungen, in denen eine harmonische Führungsgröße nahezu gleichbleibender Frequenz auszuregeln ist, den Einsatz eines Demodulators und eines nachgeschalteten Tiefpassfilters voraussetzen, die aus dem harmonischen Eingangssignal ein entsprechendes Basisbandsignal erzeugen.

In der WO 93/15447 A1 wird bezüglich der Regelung eines Antriebs eines bewegten Werkstücks oder eines bewegten Werkzeugs an einer Werkzeugmaschine eine lineare Regelung mittels einer periodischen Führungsgröße offenbart. Der Regler weist hierbei ein komplex konjungiertes Polstellenpaar, dessen Abstand vom Nullpunkt gleich der Periodenfrequenz der Führungsgröße ist.

DE 10 2008 044000 A1 offenbart ein Regelungssystem, mit dem das Nyquist-Kriterium unterlaufen werden kann, um Rechenaufwand und Chipgröße einzusparen.

Aufgabe der Erfindung ist ein verbessertes Reglerkonzept zur Rückstellung einer durch eine Störgröße bewirkten Auslenkung von im stationären Fall harmonisch schwingenden Schwingern, n Form einer der beweglich gelagerten Einheiten eines Drehratensensors. Die Aufgabe wird mit dem Gegenstand der unabhängigen Ansprüche gelöst. Vorteilhafte Weiterbildungen ergeben sich aus den jeweiligen Unteransprüchen.

Im Nachfolgenden werden anhand der Figuren Ausführungsformen der Erfindung, deren Funktionsweise sowie deren Vorteile beschrieben. Elemente der Ausführungsformen sind miteinander kombinierbar, sofern sie sich nicht ausschließen.

Die Figur 1A zeigt ein schematisches Blockschaltbild einer Vorrichtung mit einem harmonisch angeregten Schwinger und einer Reglereinheit zur Rückstellung der Auslenkung des Schwingers gemäß dem Stand der Technik.

Die Figur 1B zeigt ein schematisches Modell der Vorrichtung nach Figur 1A.

Die Figur 1C illustriert die Übertragungsfunktion eines im Basisband arbeitenden kontinuierlichen PI-Reglers.

Die Figur 1D zeigt Frequenzgangdiagramme für einen kontinuierlichen PI-Regler zur Illustration der Wirkungsweise von Reglereinheiten gemäß dem Stand der Technik.

Die Figur 2A zeigt ein schematisches Blockschaltbild einer Vorrichtung mit einer Reglereinheit gemäß einer Ausführungsform, die sich auf eine Reglereinheit mit einem kontinuierlichen PI-Regler für harmonische Führungsgrößen und einem Totzeitglied bezieht.

Die Figur 2B zeigt schematisch die Übertragungsfunktion des PI-Reglers nach Figur 2A.

Die Figur 2C zeigt schematische Frequenzgangdiagramme für die in Figur 2A dargestellte Reglereinheit.

Die Figur 3A zeigt ein schematisches Blockschaltbild einer Vorrichtung mit einer Reglereinheit gemäß einer Ausführungsform, die sich auf eine Reglereinheit mit einem diskreten PI-Regler für harmonische Führungsgrößen und einem Totzeitglied bezieht.

Die Figur 3B illustriert schematisch die Übertragungsfunktion der Reglereinheit in Figur 3A.

Die Figur 3C zeigt schematische Frequenzgangdiagramme zur Erläuterung der Wirkungsweise der in der Figur 3A dargestellten Reglereinheit.

Die Figur 3D zeigt ein vereinfachtes Blockschaltbild der ins Basisband transformierten Reglereinheit der Figur 3A gemäß einer Ausführungsform.

Die Figur 3E zeigt schematische Frequenzgangdiagramme einer diskreten Reglereinheit, die nach einer Ausführungsform eines Verfahrens zur Herstellung einer Reglereinheit umfassend die Bestimmung der Reglerparameter durch Eigenwertvorgabe dimensioniert ist.

Die Figur 4A ist ein schematisches Blockschaltbild einer Vorrichtung mit einer Reglereinheit gemäß einer Ausführungsform, die sich auf eine Reglereinheit mit einem diskreten PI-Regler für harmonische Führungsgrößen und eine ähnlich einem Bandpass wirkende Reglererweiterung bezieht.

Die Figur 4B zeigt schematisch die Übertragungsfunktion der Reglererweiterung nach Figur 4A.

Die Figur 4C zeigt Frequenzgangdiagramme zur Erläuterung der Wirkungsweise der Reglererweiterung nach Figur 4A.

Die Figur 5A ist eine schematische Draufsicht auf den mikromechanischen Teil eines Drehratensensors gemäß einer weiteren Ausführungsform der Erfindung.

Die Figur 5B ist eine schematische Querschnittsdarstellung des mikromechanischen Teils des Drehratensensors der Figur 5A.

Die Figur 5C ist ein schematisches Blockschaltbild des Drehratensensors gemäß der Figuren 5A und 5B.

Die Figur 6 ist eine schematische Draufsicht auf den mikromechanischen Teil eines Drehratensensors gemäß einer weiteren Ausführungsform der Erfindung.

Die Figur 7A zeigt ein vereinfachtes Flussdiagramm für ein Verfahren zum Betrieb eines Drehratensensors.

Die Figur 7B ist ein schematisches Flussdiagramm für ein Verfahren zur Herstellung eines Drehratensensors.

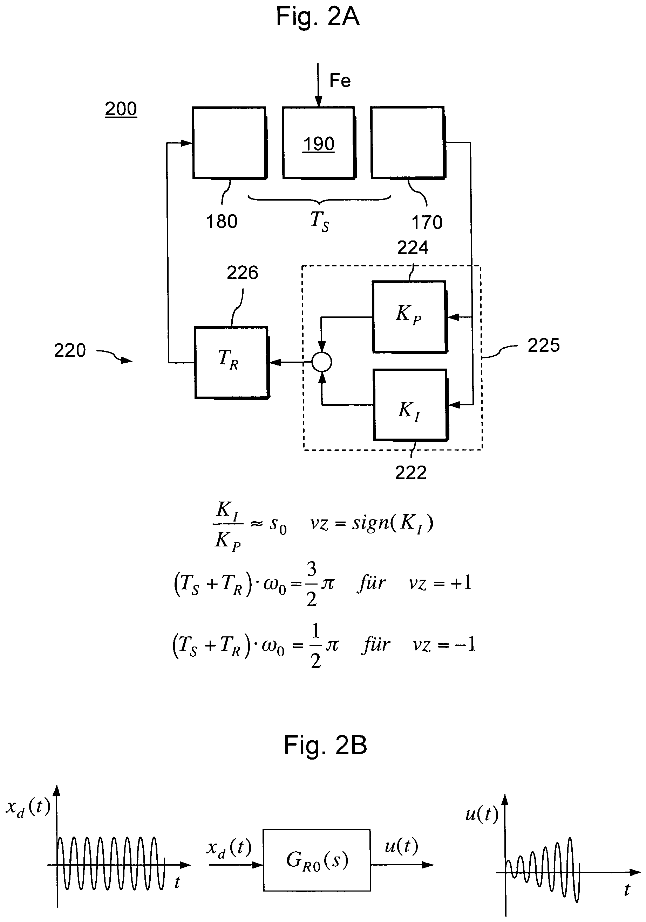

Die in der Figur 2A gezeigte Ausführungsform bezieht sich auf eine Vorrichtung 200 mit einer Reglereinheit 220, die einen PI-Regler 225 für harmonische Führungsgrößen mit einem integrierenden Übertragungsglied 222 mit dem Integrierbeiwert $K_1$ und einem proportionalen Übertragungsglied 224 mit dem Verstärkungsfaktor $K_p$ umfasst. Der PI-Regler 225 für harmonische Führungsgrößen erzeugt aus einer mit der Sprungfunktion amplitudenmodulierten harmonischen Schwingung konstanter Amplitude am Reglereingang eine harmonische Schwingung mit gleicher Frequenz und zeitproportionaler Amplitude am Reglerausgang.

Die Figur 2B illustriert die Transformation eines sinusmodulierten Sprungsignals $x_d(t)$ auf ein harmonisches Ausgangssignal u(t) mit zeitproportionaler Amplitude durch die Übertragungsfunktion $G_{R0}(s)$ des PI-Reglers 225. Das beschriebene Verhalten des PI-Reglers setzt eine Dimensionierung der Reglerparameter $K_i$, $K_p$ wie nachfolgend beschrieben voraus.

Analog der Gleichung (3) gibt Gleichung (9) den Zusammenhang zwischen dem Reglerausgangssignal u(t) und dem Reglereingangssignal $x_d(t)$ für $x_d(t) = \sigma(t)$ wieder:

$$(9) \qquad u(t) = (K_P + K_I \cdot t) \cdot \sin(\omega_0 \cdot t) \cdot \sigma(t).$$

Die Laplace-Transformierten von Reglerausgangssignal u(t) und Reglereingangssignal $x_d(t)$ ergeben sich aus den Gleichungen (9a) und (9b):

$$(9a) \qquad X_d(s) = \frac{\omega_0}{s^2 + \omega_0^2}$$

$$(9b) \qquad U(s) = K_P \cdot \frac{\omega_0}{s^2 + \omega_0^2} + K_I \cdot \frac{2 \cdot \omega_0 \cdot s}{(s^2 + \omega_0^2)^2}.$$

Die Übertragungsfunktion $G_{R0}(s)$ des PI-Reglers 225 für harmonische Führungsgrößen ergibt sich demnach nach Gleichung (10):

$$(10) \qquad G_{R0}(s) = \frac{U(s)}{X_d(s)} = K_P \cdot \frac{s^2 + 2 \cdot \dfrac{K_I}{K_P} \cdot s + \omega_0^2}{s^2 + \omega_0^2}$$

Charakteristisch für den kontinuierlichen PI-Regler 225 ist ein aus dem verallgemeinerten Integralanteil resultierender konjugiert komplexer Pol bei $s = j\omega_0$. Der PI-Regler 225 erzeugt am Reglerausgang bei einer harmonischen Schwingung der Frequenz $\omega_0$ am Reglereingang keine Phasenverschiebung. Zur Einstellung einer beliebigen Phase umfasst die Reglereinheit 220 daher zusätzlich ein Totzeitglied 226 mit einer Reglertotzeit $T_R$ in Serie zum PI-Regler 225. Die Reglerübertragungsfunktion $G_R(s)$ der Reglereinheit 220 ergibt sich demnach nach Gleichung (11):

$$(11) \qquad G_R(s) = G_{R0}(s) \cdot e^{-T_R \cdot s} = K_P \frac{s^2 + 2 \cdot \dfrac{K_I}{K_P} \cdot s + \omega_0^2}{s^2 + \omega_0^2} \cdot e^{-T_R \cdot s}$$

Die Reglerparameter $K_i$, $K_p$ werden so gewählt, dass die Reglernullstellen in der Reglerübertragungsfunktion nach Gleichung (11) den konjugiert komplexen Streckenpol in der Streckenübertragungsfunktion nach Gleichung (1) kompensieren. Durch Koeffizientenvergleich der Gleichungen (1) und (11) ergeben sich zur Bestimmung der Reglerparameter $K_i$, $K_p$ die Gleichungen (12a) und (12b):

$$(12a) \qquad 2 \cdot \frac{K_I}{K_P} \overset{!}{=} 2 \cdot s_0$$

$$(12b) \qquad \omega_0^2 \overset{!}{=} \omega_0^2 + s_0^2.$$

Gemäß einer Ausführungsform werden die Dämpfung $s_0$ und die Resonanzkreisfrequenz $\omega_0$ des Schwingers 190 so gewählt, dass $s_0 \ll \omega_0$ gilt und damit Gleichung (12b) in sehr guter Näherung erfüllt ist. Aus der Gleichung (12a) ergibt sich Gleichung (12c) als Dimensionierungsvorschrift für das Verhältnis von Integrierbeiwert K, zu Verstärkungsfaktor $K_P$:

$$(12c) \qquad \frac{K_I}{K_P} \overset{!}{=} s_0.$$

Die Übertragungsfunktion $G_k(s)$ des korrigierten offenen Kreises ergibt sich aus dem Produkt von Streckenübertragungsfunktion $G_S(s)$ und Reglerübertragungsfunktion $G_R(s)$. Da sich bei entsprechender Dimensionierung nach Gleichung (12b), (12c) die Ausdrücke für den konjugiert komplexen Streckenpol und die konjugiert komplexe Reglernullstelle wegkürzen, ergibt sich die Übertragungsfunktion $G_k(s)$ des korrigierten offenen Kreises nach Gleichung (13):

$$(13) \qquad G_k(s) = G_S(s) \cdot G_R(s) = A \cdot K_P \cdot \frac{1}{s^2 + \omega_0^2} \cdot e^{-(T_S + T_R) \cdot s}$$

Bei Regelung mit konventionellem PI-Regler tritt im Phasenfrequenzgang des korrigierten offenen Kreises bei der Frequenz $\omega = 0$ ein Phasensprung von +90° nach -90° auf. Dagegen tritt in dem für harmonische Führungsgrößen ausgelegten PI-Regler 225 bei der Frequenz $\omega_0$ ein 180°-Phasensprung auf, der jedoch nicht notwendigerweise zwischen +90° und - 90° erfolgt. Gemäß einer Ausführungsform wird daher die Reglertotzeit $T_R$ so gewählt, dass der 180°-Phasensprung möglichst genau bei $\omega_0$ auftritt, beispielsweise indem die Reglerparameter nach Gleichung (14a) dimensioniert werden:

$$(14a) \qquad (T_S + T_R) \cdot \omega_0 = \frac{3}{2} \cdot \pi$$

Ist die allein durch die Streckentotzeit $T_S$ hervorgerufene Phasenverschiebung bei $\omega_0$ kleiner 90°, so kann ein Phasenanteil von 180° auch durch einen invertierenden Regler erzeugt werden. In diesem Fall müssen sich die durch die Reglertotzeit $T_R$ und Streckentotzeit $T_S$ hervorgerufenen Phasen bei $\omega_0$ lediglich zu $\pi/2$ ergänzen. Die Dimensionierungsvorschrift für die Reglertotzeit $T_R$ lautet dann:

$$(14b) \qquad (T_S + T_R) \cdot \omega_0 = \frac{\pi}{2}.$$

Aus dem Frequenzgang des korrigierten offenen Kreises kann mittels des Nyquist-Kriteriums auf die Stabilitätseigenschaften des geschlossenen Kreises geschlossen werden. Der korrigierte offene Kreis besteht aus dem verallgemeinerten Integrator und der Kombination aus Streckentotzeit $T_S$ und Reglertotzeit $T_R$. Durch geeignete Dimensionierung der Reglertotzeit $T_R$ nach einer der Gleichungen (14a) oder (14b) weist die Phasenkennlinie bei der Frequenz $\omega_0$ einen 180°-Sprung zwischen +90° für tiefere Frequenzen $\omega < \omega_0$ nach -90° zu höheren Frequenzen $\omega > \omega_0$ hin auf. Die Übertragungsfunktion $G_w(s)$ des geschlossenen Kreises ergibt sich aus der des korrigierten offenen Kreises $G_k(s)$ wieder nach Gleichung (8):

$$(15) \qquad G_w(s) = \frac{G_k(s)}{1 + G_k(s)}.$$

Wird die Reglertotzeit $T_R$ gemäß Gleichung (14a) bestimmt, so ist der geschlossene Kreis genau dann stabil, wenn die Ortskurve des korrigierten offenen Kreises für $0 \leq \omega < \omega_0$ den Punkt -1 weder umschließt noch durchdringt.

Wird dagegen die Reglertotzeit $T_R$ anhand der Gleichung (14b) bestimmt und erzeugt der PI-Regler 225 eine 180°-Phase, so ist der geschlossene Kreis genau dann stabil, wenn die Ortskurve des korrigierten offenen Kreis auf der negativen reellen Achse bei einem Wert größer -1 beginnt.

Im Intervall $0 \leq \omega < \omega_0$ schneidet die Betragskennlinie die 0 dB Linie bei der Durchtrittsfrequenz, wobei der Frequenzabstand der Durchtrittsfrequenz zu $\omega_0$ die Bandbreite des geschlossenen Kreises bestimmt. Über den Verstärkungsfaktor $K_P$ lassen sich der Betragsfrequenzgang und damit die Durchtrittsfrequenz in Ordinatenrichtung verschieben, so dass die resultierende Bandbreite für den geschlossenen Kreis einstellbar ist. Gemäß einer Ausführungsform wird der Verstärkungsfaktor $K_P$ im Rahmen der durch die Stabilitätskriterien vorgegebenen Grenzen so gewählt, dass die Bandbreite maximal ist.

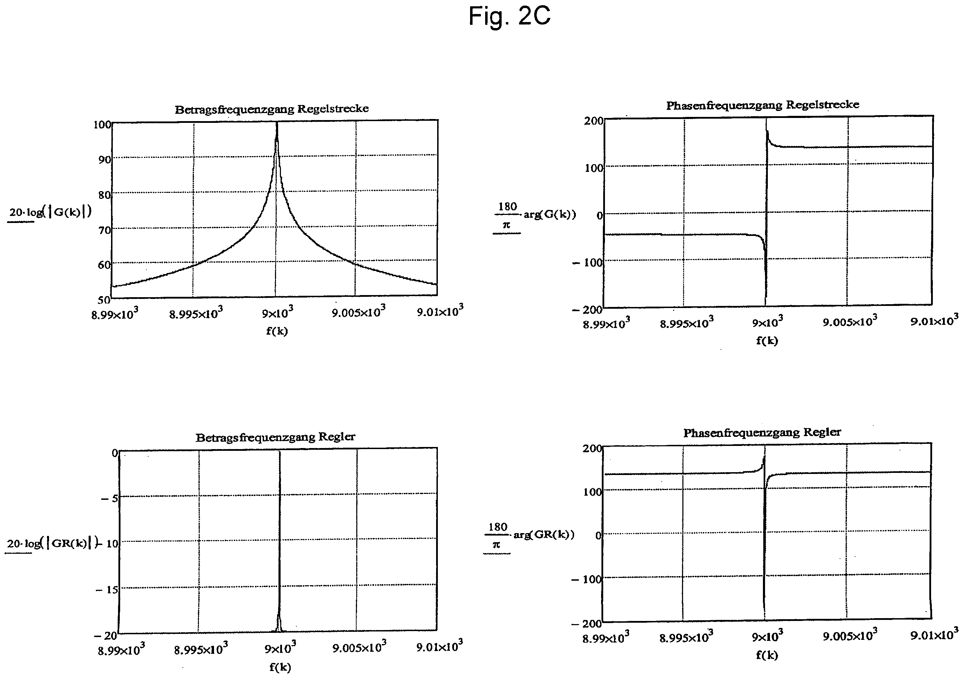

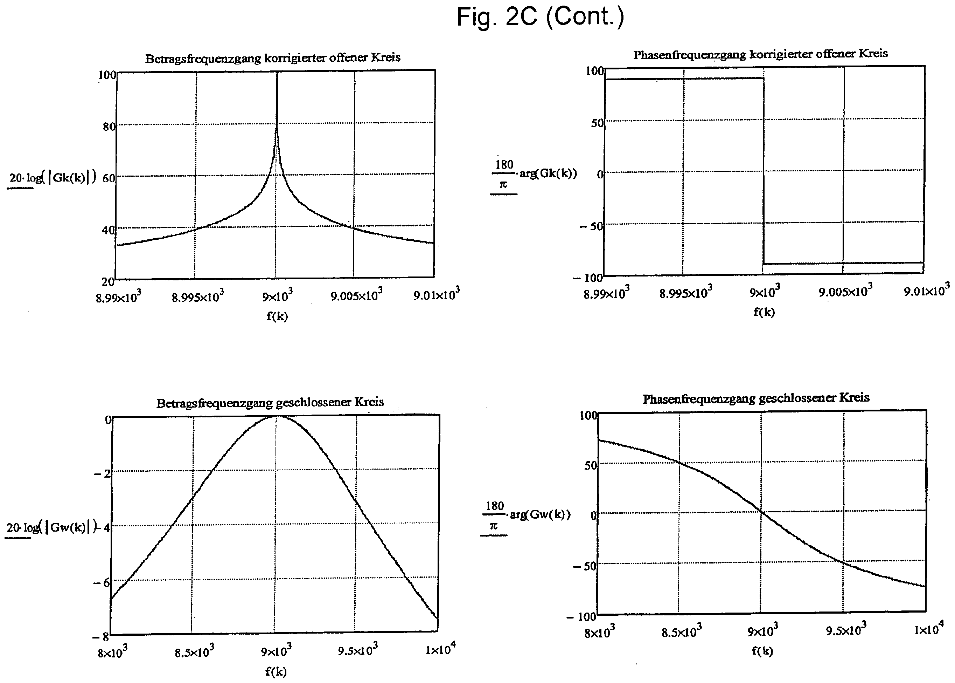

Die Figur 2C zeigt in der linken Spalte von oben nach unten die Betragsfrequenzgänge für Regelstrecke, Regler, den korrigierten offenen Kreis sowie den geschlossenen Kreis und in der rechten Spalte Phasenfrequenzgänge für Regelstrecke, Regler, korrigiertem offenen Kreis und geschlossenem Kreis für eine Ausführungsform, bei der die Streckenparameter wie folgt angesetzt sind:

Resonanzkreisfrequenz des Schwingers $\omega_0 = 2 \cdot \pi \cdot 9000$ Hz,

Dämpfung des Schwingers $s_0 = \dfrac{\omega_0}{200000}$,

Verstärkung $A = s_0^2 + \omega_0^2$ und

Streckentotzeit $T_S = \dfrac{\pi}{4 \cdot \omega_0}$.

Die Reglernullstelle ist so gewählt, dass der Streckenpol kompensiert ist. Da die durch die Streckentotzeit hervorgerufene Phase bei $\omega_0$ kleiner ist als 90° kann der Phasenanteil von 180° durch ein Minuszeichen im Regler (invertierenden Regler) realisiert werden. Für einen Verstärkungsfaktor $K_P$ = -1/10 ergibt sich der Integrierbeiwert $K_I$ nach Gleichung (12c) und die Reglertotzeit $T_R$ nach Gleichung (14b) zu $T_R= \pi/4 \cdot \omega_0$.

Die resultierende Bandbreite des geschlossenen Kreises beträgt etwa 500 Hz und ist deutlich größer als im Vergleichsbeispiel für den konventionellen, im Basisband betriebenen PI-Regler.

Die in der Figur 2A gezeigte Vorrichtung 200 umfasst einen Schwinger 190 und eine Reglereinheit 220. Der Schwinger 190 ist eine Masse, die entlang einer Anregungsrichtung beweglich ist und entlang der Anregungsrichtung mit einer Resonanzkreisfrequenz $\omega_0$ zu schwingen vermag. Im stationären Fall, d.h. ohne Beaufschlagung mit einer Störgröße, führt der Schwinger 190 eine translatorische oder rotatorische Schwingung mit der Resonanzkreisfrequenz $\omega_0$ aus. Dieser Schwingung überlagert sich eine durch eine Kraftamplitude F bewirkte Auslenkung. Ein Sensor 170 erfasst die Bewegung des Schwingers 190 und gibt ein Messsignal aus, das die gesamte Auslenkung des Schwingers 190 entlang der Anregungsrichtung abbildet. Das Messsignal entspricht einem Reglereingangssignal für die Reglereinheit 220. Die Reglereinheit 220 erzeugt aus dem Reglereingangssignal ein Reglerausgangssignal und gibt das Reglerausgangssignal an einen Aktuator 180 aus. Der Aktuator 180 wirkt der durch das Kraftsignal F bewirkten Auslenkung des Schwingers 190 entgegen, bzw. kompensiert diese, so dass der Schwinger 190 eine harmonische Schwingung konstanter Amplitude mit der Resonanzkreisfrequenz $\omega_0$ ausführt.

Die Reglereinheit 220 weist einen PI-Regler 225 für harmonische Führungsgrößen auf, der ein proportionales Übertragungsglied 224 mit einem Verstärkungsfaktor $K_P$ und ein integrierendes Übertragungsglied 222 mit einem Integrierbeiwert $K_I$ umfasst. Der Integrierbeiwert $K_I$ und der Verstärkungsfaktor $K_P$ sind so gewählt, dass sich in der s-Ebene die Nullstelle der Reglerübertragungsfunktion des PI-Reglers 225 und der konjugiert komplexe Pol der den Schwinger 190 beschreibenden Streckenübertragungsfunktion kompensieren.

Gemäß einer Ausführungsform ist die Dämpfung $s_0$ des Schwingers 190 bezüglich der Auslenkung in der Anregungsrichtung sehr viel kleiner als die Resonanzkreisfrequenz $\omega_0$ des Schwingers 190 und das Verhältnis des Integrierbeiwerts K, zum Verstärkungsfaktor $K_P$ in sec$^{-1}$ entspricht in etwa der Dämpfung $s_0$. Zudem kann der Verstärkungsfaktor $K_P$ so gewählt werden, dass die resultierende Bandbreite für die jeweilige Stabilitätsanforderung möglichst hoch ist. Der Integrierbeiwert $K_I$ wird dann in Abhängigkeit von der Dämpfung $s_0$ und dem Verstärkungsfaktor $K_P$ nach Gleichung (12c) gewählt.

Nach einer Ausführungsform weist das aus dem Aktuator 180, dem Schwinger 190 und dem Sensor 170 gebildete System eine Streckentotzeit $T_S$ und die Reglereinheit 220 eine seriell zum PI-Regler 225 wirkendes Totzeitglied 226 mit der Reglertotzeit $T_R$ auf. Die Reglertotzeit $T_R$ wird in Abhängigkeit von der Resonanzkreisfrequenz $\omega_0$ des Schwingers 290 und der Streckentotzeit $T_S$ so gewählt, dass der Phasenfrequenzgang des korrigierten offenen Kreises bei der Frequenz $\omega_0$ einen Phasensprung von +90° nach -90° zu höheren Frequenzen hin aufweist.

Nach einer ersten Variante dieser Ausführungsform dreht der PI-Regler für harmonische Führungsgrößen das Vorzeichen nicht und die Reglertotzeit $T_R$ wird so gewählt, dass das Produkt aus der Resonanzkreisfrequenz $\omega_0$ und der Summe aus Streckentotzeit $T_S$ und Reglertotzeit $T_R$ als Ergebnis $3\pi/2$ ergibt. Nach einer anderen Variante dieser Ausführungsform invertiert der PI-Regler 225 das Vorzeichen, bzw. schiebt die Phase um 180°, und die durch Reglertotzeit $T_R$ und Streckentotzeit $T_S$ hervorgerufene Phase bei der Resonanzkreisfrequenz $\omega_0$ wird lediglich zu $\pi/2$ ergänzt, so dass das Produkt aus der Resonanzkreisfrequenz $\omega_0$ und der Summe aus Streckentotzeit $T_S$ und Reglertotzeit $T_R$ als Ergebnis $\pi/2$ ergibt.

Da die Regeleinheit 220 keine Basisbandtransformation vorsieht, die zum Dämpfen von höherfrequenten Mischprodukten ein Tiefpassfilter erforderlich macht, kann die Reglereinheit 220 deutlich breitbandiger ausgelegt werden. Die Reglereinheit 220 reagiert schneller auf Störgrößen als vergleichbare Regler, die eine Basisbandtransformation vorsehen.

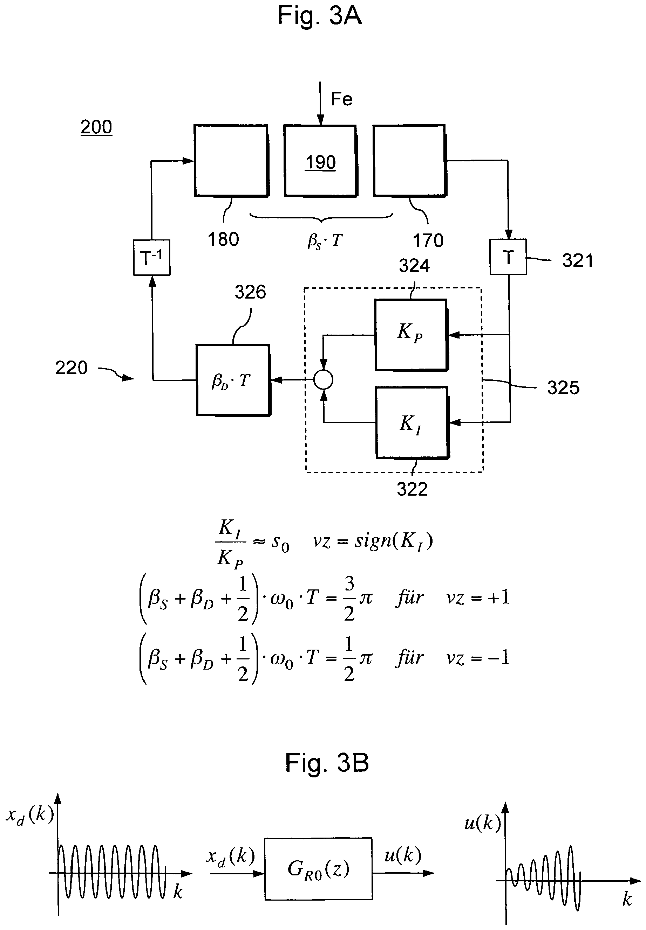

Die Figuren 3A bis 3E beziehen sich auf eine Ausführungsform, bei der die Reglereinheit 220 einen diskreten PI-Regler 325 für harmonische Führungsgrößen mit einem diskreten proportionalen Übertragungsglied 324 mit dem Verstärkungsfaktor $K_P$ und einem diskreten integrierenden Übertragungsglied 322 mit dem Integrierbeiwert $K_I$ aufweist. Gemäß einer Ausführungsform ist das vom Sensor 170 ein analoges Messsignal, das eine Abtasteinheit 321 mit einer Abtastzeit T abtastet und in ein digitales Eingangssignal für diskreten PI-Regler 325 umwandelt. Gemäß einer anderen Ausführungsform gibt der Sensor 170 bereits ein digitales Messsignal aus.

Gemäß einer Ausführungsform, bei der das den Aktuator 180, den Schwinger 190 und den Sensor 170 umfassende System eine Streckentotzeit $T_S$ aufweist, umfasst die Reglereinheit 220 ein in Serie zum diskreten PI-Regler 325 angeordnetes Totzeitglied 326 mit einer Reglertotzeit $T_R$. Im Weiteren werden sowohl die Streckentotzeit $T_S$ als auch die Reglertotzeit $T_R$ gemäß den Gleichungen (16a) und (16b) als Vielfache der Abtastzeit T ausgedrückt:

$$(16a), (16b) \qquad T_S = \beta_S \cdot T \text{ und } T_R = \beta_D \cdot T.$$

Die Reglertotzeit $T_R$ wird dabei so bestimmt, dass der korrigierte offene Kreis bei der Resonanzkreisfrequenz $\omega_0$ einen Phasensprung von +90° und -90° zu höheren Frequenzen hin aufweist.

Gemäß einer Ausführungsform ist das Verhältnis des Integrierbeiwerts $K_I$ zum Verstärkungsfaktor $K_P$ so eingestellt, dass in der s-Ebene die Reglernullstellen der Reglerübertragungsfunktion den konjugiert komplexen Streckenpol der Streckenübertragungsfunktion kompensieren. Gemäß einer anderen Ausführungsform sind die Reglerparameter so gewählt, dass die Übertragungsfunktion des geschlossenen Kreises eines äquivalenten Basisbandsystems einen doppelten reellen Eigenwert aufweist. Die Reglereinheit 220 ist beispielsweise als digitaler Schaltkreis realisiert, zum Beispiel als ASIC (anwenderspezifischer integrierter Schaltkreis), DSP (digitaler Signalprozessor) oder FPGA (Field Programmable Gate Array).

Die Figur 3B illustriert die z-Übertragungsfunktion $G_{R0}(z)$ des diskreten PI-Reglers 325 für harmonische Führungsgrößen gemäß Figur 3A. Die Übertragungsfunktion $G_{R0}(z)$ wird so bestimmt, dass der PI-Regler 325 aus einem Eingangssignal $x_d(k)$ umfassend eine mit der Sprungfunktion $\sigma(k)$ modulierte harmonische Schwingung eine harmonische Schwingung gleicher Frequenz mit zeitproportionaler Amplitude als Reglerausgangssignal $u(k)$ erzeugt, wie durch Gleichung (17) ausgedrückt:

$$(17) \qquad u(k) = (K_P + K_I \cdot T \cdot k) \cdot \sin(\omega_0 \cdot T \cdot k) \cdot \sigma(k)$$

Die Eingangsfunktion $X_d(z)$ und Ausgangsfunktion $U(z)$ ergeben sich durch z-Transformation nach den Gleichungen (18a) und (18b):

$$(18a) \qquad X_d(z) = \frac{z \cdot \sin(\omega_0 \cdot T)}{z^2 - 2 \cdot \cos(\omega_0 \cdot T) \cdot z + 1}$$

$$(18b) \qquad U(z) = K_P \cdot \frac{z \cdot \sin(\omega_0 \cdot T)}{z^2 - 2 \cdot \cos(\omega_0 \cdot T) \cdot z + 1} + K_I \cdot \frac{T \cdot z^3 \cdot \sin(\omega_0 \cdot T) - T \cdot z \cdot \sin(\omega_0 \cdot T)}{(z^2 - 2 \cdot \cos(\omega_0 \cdot T) \cdot z + 1)^2}$$

Die Übertragungsfunktion $G_{R0}(z)$ des diskreten PI-Reglers 325 für harmonische Führungsgrößen ergibt sich dann nach Gleichung (18c):

$$(18c) \qquad G_{R0}(z) = \frac{U(z)}{X_d(z)} = \frac{(K_P + K_I \cdot T) \cdot z^2 - 2 \cdot K_P \cdot \cos(\omega_0 \cdot T) \cdot z + K_P - K_I \cdot T}{z^2 - 2 \cdot \cos(\omega_0 \cdot T) \cdot z + 1}$$

Ein solcher diskreter PI-Regler weist infolge des verallgemeinerten Integralanteils einen Pol bei $z = e^{\pm j \cdot \omega_0 \cdot T}$ auf und erzeugt bei einer harmonischen Schwingung der Frequenz $\omega_0$ am Eingang keine Phasenverschiebung am Ausgang. Um dennoch eine beliebige Phase einstellen zu können, wird die Reglereinheit 220 gemäß einer Ausführungsform mit einem Totzeitglied 326 mit der Verzögerung $\beta_D$ vorgesehen. Die Reglerübertragungsfunktion $G_R(z)$ der Reglereinheit 220 mit dem Totzeitglied 326 und dem diskreten PI-Regler 325 ergibt sich dann nach Gleichung (19):

$$(19) \qquad G_R(z) = G_{R0}(z) \cdot z^{-\beta_D} = \frac{(K_P + K_I \cdot T) \cdot z^2 - 2 \cdot K_P \cdot \cos(\omega_0 \cdot T) \cdot z + K_P - K_I \cdot T}{z^2 - 2 \cdot \cos(\omega_0 \cdot T) \cdot z + 1} \cdot z^{-\beta_D}$$

Das Modell der kontinuierlichen Regelstrecke nach Gleichung (1) ist in entsprechender Weise zu diskretisieren. Dazu wird zunächst in der Übertragungsfunktion G(s) der Regelstrecke nach Gleichung (1) die Streckentotzeit $T_s$ gemäß Gleichung (16a) als Vielfaches der Abtastzeit T ausgedrückt:

$$(20) \qquad G(s) = \frac{A}{(s + s_0)^2 + \omega_0^2} \cdot e^{-\beta_s \cdot T_s} = G_0(s) \cdot e^{-\beta_s T_s}$$

Allgemein lässt sich die Stufenübertragungsfunktion G(z) für ein diskretisiertes Modell einer kontinuierlichen Regelstrecke mit der Übertragungsfunktion G(s) nach Gleichung (21) berechnen:

$$(21) \qquad G(z) = \frac{z-1}{z} \cdot Z\left\{ \frac{G(s)}{s} \right\}$$

Mit den folgenden Abkürzungen nach Gleichungen (21a) bis (21e)

$$(21a) \qquad K_S = \frac{A}{s_0^2 + \omega_0^2}$$

$$(21b) \qquad b_1 = 1 - e^{-s_0 \cdot T} \cdot \cos(\omega_0 \cdot T) - \frac{s_0}{\omega_0} \cdot e^{-s_0 \cdot T} \cdot \sin(\omega_0 \cdot T)$$

$$(21c) \qquad b_2 = e^{-2 \cdot s_0 \cdot T} - e^{-s_0 \cdot T} \cdot \cos(\omega_0 \cdot T) + \frac{s_0}{\omega_0} \cdot e^{-s_0 \cdot T} \cdot \sin(\omega_0 \cdot T)$$

$$(21d) \qquad a_1 = 2 \cdot e^{-s_0 \cdot T} \cdot \cos(\omega_0 \cdot T)$$

$$(21e) \qquad a_2 = -e^{-2 \cdot s_0 \cdot T}$$

ergibt sich die Stufenübertragungsfunktion G(z) für den Schwinger 190 aus den Gleichungen (20) und (21) nach Gleichung (22):

$$(22) \qquad G(z) = K_S \cdot \frac{b_1 \cdot z + b_2}{z^2 - a_1 \cdot z - a_2} \cdot \frac{1}{z^{\beta_s}} = G_0(z) \cdot \frac{1}{z^{\beta_s}}$$

Nach einer Ausführungsform der Erfindung wird die Reglertotzeit $T_R$ so bestimmt, dass der Phasenfrequenzgang des korrigierten offenen Kreises bei der Resonanzkreisfrequenz $\omega_0$ einen Phasensprung von +90° nach -90° zu höheren Frequenzen hin aufweist. Die Z-Übertragungsfunktion für den korrigierten offenen Kreis ergibt sich analog zur Gleichung (13) aus der Multiplikation der Streckenübertragungsfunktion G(z) nach Gleichung (20) mit der Reglerübertragungsfunktion $G_R(z)$ nach Gleichung (19):

$$(23) \qquad G_K(z) = G_0(z) \cdot G_{R0}(z) \cdot z^{-(\beta_S + \beta_D)}$$

Analog zu den Gleichungen (14a) und (14b) wird der Reglerparameter $\beta_D$ so gewählt, dass bei der Resonanzkreisfrequenz $\omega_0$ die Übertragungsfunktion des korrigierten offenen Kreises $G_K(z)$ einen Phasensprung von +90° nach -90° aufweist:

$$(24a) \qquad (\beta_S + \beta_D + \frac{1}{2}) \cdot \omega_0 \cdot T = \frac{3}{2} \cdot \pi$$

Im Vergleich mit Gleichung (14a) ergibt sich gegenüber dem kontinuierlichen Regler ein zusätzlicher Anteil von ½$\omega_0$T, der eine auf die Diskretisierung zurückzuführende Verzögerung von einem zusätzlichen, halben Abtasttakt wiedergibt. Wie auch im Fall des kontinuierlichen Reglers kann, sofern die durch die Streckentotzeit $\beta_S \cdot T$ und die Diskretisierung hervorgerufene Phasenverschiebung bei der Resonanzkreisfrequenz $\omega_0$ kleiner als 90° ist, ein Phasensprung von 180° auch durch ein Minuszeichen im Regler erzeugt werden, so dass sich die durch die Diskretisierung, die Reglertotzeit $\beta_D \cdot T$ und die Streckentotzeit $\beta_S \cdot T$ hervorgerufenen Phasen bei der Resonanzkreisfrequenz $\omega_0$ lediglich zu $\pi$/2 ergänzen müssen. Entsprechend ergibt sich für diesen Fall für $\beta_D$ die Dimensionierungsvorschrift nach Gleichung (24b):

$$(24b) \qquad (\beta_S + \beta_D + \frac{1}{2}) \cdot \omega_0 \cdot T = \frac{\pi}{2} \cdot$$

Die Gleichungen (24a) und (24b) führen in der Regel zu einem nicht ganzzahligen Wert für $\beta_D$. Im Allgemeinen weist der Reglerparameter $\beta_D$ einen ganzzahligen Anteil $n_D$ und einen Rest $1/a_D$ mit $a_D > 1$ gemäß Gleichung (25) auf:

$$(25) \qquad \beta_D = n_D + \frac{1}{a_D}$$

Gemäß einer Ausführungsform wird der ganzzahlige Anteil $n_D$ durch eine Verzögerungskette entsprechend der durch $n_D$ angegebenen Länge und der Bruchteil $1/a_D$ eines Abtasttaktes durch einen Allpass erster Ordnung gemäß Gleichung (26) approximiert:

$$(26) \qquad z^{-\frac{1}{a_D}} \approx \frac{\alpha_D \cdot z + 1}{z + \alpha_D}$$

Gemäß einer Ausführungsform wird der Parameter $\alpha_D$ des Allpasses so gewählt, dass die Phase der exakten Übertragungsfunktion $z^{-a_D^{-1}}$ und die Phase der Allpass-Approximation nach Gleichung (26) bei der Resonanzkreisfrequenz $\omega_0$ möglichst exakt übereinstimmen. Aus dieser Bedingung ergibt sich als Bestimmungsgleichung für den Parameter $\alpha_D$ des Allpasses die Gleichung (27):

$$(27) \qquad -\frac{\omega_0 \cdot T}{a_D} = \arctan\left(\frac{\alpha_D \cdot \sin(\omega_0 \cdot T)}{\alpha_D \cdot \cos(\omega_0 \cdot T) + 1}\right) - \arctan\left(\frac{\sin(\omega_0 \cdot T)}{\cos(\omega_0 \cdot T) + \alpha_D}\right)$$

Gemäß einer Ausführungsform wird $\alpha_D$ dadurch bestimmt, dass per Intervallschachtelung die Nullstelle der Funktion gemäß Gleichung (28) ermittelt wird:

$$(28) \qquad f(\alpha_D) = \arctan\left(\frac{\alpha_D \cdot \sin(\omega_0 \cdot T)}{\alpha_D \cdot \cos(\omega_0 \cdot T) + 1}\right) - \arctan\left(\frac{\sin(\omega_0 \cdot T)}{\cos(\omega_0 \cdot T) + \alpha_D}\right) + \frac{\omega_0 \cdot T}{a_D}$$

Die Bestimmung von $n_D$ und $a_D$ nach Gleichung (25) und (28) ist unabhängig von der Art der Bestimmung der weiteren Reglerparameter $K_P$ und $K_I$.

Gemäß einer Ausführungsform eines Verfahrens zur Herstellung einer Reglereinheit, das die Dimensionierung des diskreten PI-Reglers 325 nach Figur 3A umfasst, werden der Verstärkungsfaktor $K_P$ und der Integrierbeiwert $K_I$ des diskreten PI-Reglers 325 so gewählt, dass die Reglernullstellen in der Reglerübertragungsfunktion $G_R(z)$ gemäß Gleichung (19) den konjugiert komplexen Streckenpol der Streckenübertragungsfunktion $G(z)$ gemäß Gleichung (22) kompensieren. Ein Koeffizientenvergleich zwischen den Gleichungen (19) und (22) bezüglich $z^1$ führt zur Dimensionierungsvorschrift nach Gleichung (29):

$$(29) \qquad K_P \overset{!}{=} K_I \cdot T \cdot \frac{e^{-s_0 \cdot T}}{1 - e^{-s_0 \cdot T}}$$

Der Koeffizientenvergleich für $z^\circ$ führt zur Dimensionierungsvorschrift nach Gleichung (30):

$$(30) \qquad K_P \overset{!}{=} K_I \cdot T \cdot \frac{1 + e^{-2 \cdot s_0 \cdot T}}{1 - e^{-2 \cdot s_0 \cdot T}}$$

Gemäß einer Ausführungsform werden die Dämpfung $s_0$ des Schwingers 190 und die Abtastzeit T so gewählt, dass $s_0 \cdot T \ll 1$ gilt, so dass hinreichend genau die Näherungen nach (31a) und (31b) gelten:

$$(31a) \qquad e^{-s_0 \cdot T} \approx 1 - s_0 \cdot T$$

$$(31b) \qquad e^{-2 \cdot s_0 \cdot T} \approx 1 - 2 \cdot s_0 \cdot T$$

Mit den Näherungen gemäß den Gleichungen (31a) und (31b) lassen sich die beiden unabhängigen Dimensionierungsvorschriften gemäß den Gleichungen (29) und (30) durch eine einzige Dimensionierungsvorschrift nach Gleichung (32) annähern:

$$(32) \qquad K_P \overset{!}{=} K_I \cdot T \cdot \frac{1 - s_0 \cdot T}{s_0 \cdot T} \quad \text{bzw.} \quad K_I \cdot T \overset{!}{=} K_P \cdot s_0 \cdot T.$$

Gemäß einer Ausführungsform wird das Verhältnis des Integrierbeiwerts $K_I$ zum Verstärkungsfaktor $K_P$ gleich oder annähernd gleich der Dämpfung $s_0$ des Schwingers gesetzt. Die Dimensionierung des diskreten PI-Reglers 325 gemäß dem beschriebenen Verfahren, das die Kompensation des Streckenpols durch die Reglernullstelle vorsieht, führt zu einem guten Führungsverhalten des geschlossenen Kreises.

Gemäß einer anderen Ausführungsform eines Verfahrens zur Herstellung einer Reglereinheit, das die Dimensionierung eines diskreten PI-Reglers 325 umfasst, werden der Integrierbeiwert $K_I$ und der Verstärkungsfaktor $K_P$ durch geeignete Eigenwertvorgabe für ein aus dem diskreten PI-Regler 325 und einem diskreten Basisbandmodell des Schwingers 190 gebildetes System bestimmt. Dazu wird zunächst ein zum Schwingermodell $G_0(s)$ der Gleichung (1) äquivalentes Basisbandmodell $G_0'(s)$ angesetzt:

$$(33) \qquad G_0{}'(s) = \frac{A'}{s + s_0}$$

Die Parameter des äquivalenten Basisbandmodells nach Gleichung (33) werden nach Gleichung (34) so bestimmt, dass der Betrag von $G_0'(s)$ bei $\omega = 0$ mit dem Betrag von $G_0(s)$ bei $\omega = \omega_0$ übereinstimmt:

$$(34) \qquad \left|\frac{A'}{s + s_0}\right|_{\omega=0} \overset{!}{=} \left|\frac{A}{(s + s_0)^2 + \omega_0{}^2}\right|_{\omega=\omega_0}$$

Nach einer Ausführungsform wird der Schwinger 190 so realisiert, dass $\omega_0 \gg s_0$ gilt und der Zusammenhang zwischen den Parametern A und A in guter Näherung durch Gleichung (35) beschrieben werden kann:

$$(35) \qquad A' = \frac{A}{2 \cdot \omega_0}$$

Analog der Gleichung (21) ergibt sich für die Diskretisierung des äquivalenten Basisband-Modells $G_0'(s)$ Gleichung (36)

$$(36) \qquad G_0{}'(z) = \frac{z-1}{z} \cdot Z\left\{\frac{G_0{}'(s)}{s}\right\}$$

Aus den Gleichungen (33) und (36) ergibt sich das äquivalente diskretisierte Basisbandmodell nach Gleichung (37).

$$(37) \qquad G_0{}'(z) = \frac{A'}{s_0} \cdot \frac{1 - e^{-s_0 \cdot T}}{z - e^{-s_0 \cdot T}}$$

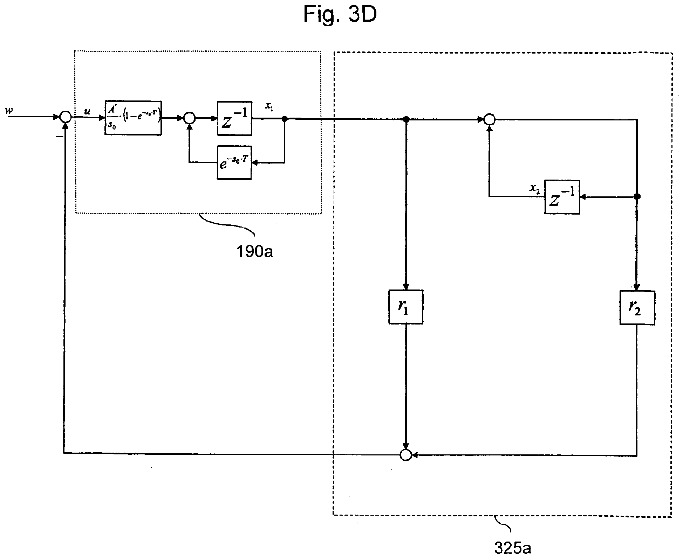

Die Figur 3D zeigt das diskretisierte Basisbandmodell 190a des Schwingers 190 nach Gleichung (37) sowie ein Reglermodell 325a für den diskreten PI-Regler 325 für harmonische Führungsgrößen nach Figur 3A mit funktionalen Untereinheiten. Das Ausgangssignal des Reglermodells 325a ist auf den Eingang des diskretisierten Basisbandmodells 190a zurückgekoppelt. Die funktionalen Untereinheiten des Reglermodells 325a können vollständig oder teilweise ausschließlich durch Hardware, zum Beispiel durch integrierte Schaltkreise, FPGAs (field programmable gate arrays), ASICs (application specific integrated circuits) oder DSPs (digital signal processors), ausschließlich durch Software, die beispielsweise in einem DSP oder einem Computer implementiert wird, oder durch eine Kombination aus Hard- und Software realisiert werden.

Das in der Figur 3D dargestellte System mit dem diskretisierten Basisbandmodell 190a und dem Reglermodell 325a lässt sich durch das Zustandsmodell gemäß den Gleichungen (38a), (38b) beschreiben:

(38a)

$$\underline{x}(k+1) = \begin{bmatrix} e^{-s_0 \cdot T} - (r_1 + r_2) \cdot \dfrac{A'}{s_0} \cdot (1 - e^{-s_0 \cdot T}) & -r_2 \cdot \dfrac{A'}{s_0} \cdot (1 - e^{-s_0 \cdot T}) \\ 1 & 1 \end{bmatrix} \cdot \underline{x}(k+1) + \begin{bmatrix} \dfrac{A'}{s_0} \cdot (1 - e^{-s_0 \cdot T}) \\ 0 \end{bmatrix} \cdot w(k)$$

$$(38b) \quad \underline{x}(k+1) = \underline{\phi} \cdot \underline{x}(k) + \underline{h} \cdot w(k)$$

Die Berechnung der Determinante $\det(z \cdot \underline{I} - \underline{\Phi})$ führt auf das charakteristische Polynom dieses Systems nach Gleichung (39b):

$$(39a) \quad \det(z \cdot \underline{I} - \underline{\Phi}) = \begin{vmatrix} z - e^{-s_0 \cdot T} + (r_1 + r_2) \cdot \dfrac{A'}{s_0} \cdot (1 - e^{-s_0 \cdot T}) & r_2 \cdot \dfrac{A'}{s_0} \cdot (1 - e^{-s_0 \cdot T}) \\ -1 & z - 1 \end{vmatrix}$$

$$(39b) \quad \det(z \cdot I - \underline{\Phi}) = z^2 - (1 + e^{-s_0 \cdot T} - (r_1 + r_2) \cdot \dfrac{A'}{s_0} \cdot (1 - e^{-s_0 \cdot T})) \cdot z +$$

$$e^{-s_0 \cdot T} - (r_1 + r_2) \cdot \dfrac{A'}{s_0} \cdot (1 - e^{-s_0 \cdot T}) + r_2 \cdot \dfrac{A'}{s_0} \cdot (1 - e^{-s_0 \cdot T})$$

Die Berechnung der Nullstellen des charakteristischen Polynoms gemäß Gleichung (39b) liefert die Eigenwerte $\lambda_1$, $\lambda_2$ des geregelten Systems, für die sich das charakteristische Polynom allgemein in der Form nach Gleichung (40) darstellen lässt:

$$(40) \quad (z - \lambda_1) \cdot (z - \lambda_2) = z^2 - (\lambda_1 + \lambda_2) \cdot z + \lambda_1 \cdot \lambda_2$$

Durch Koeffizientenvergleich zwischen den Gleichungen (39b) und (40) ergeben sich die Reglerkoeffizienten in Abhängigkeit der vorzugebenden Eigenwerte $\lambda_1$ und $\lambda_2$ aus den Gleichungen (41a) und (41b).

$$(41a) \quad 1 + e^{-s_0 \cdot T} - (r_1 + r_2) \cdot \dfrac{A'}{s_0} \cdot (1 - e^{-s_0 \cdot T}) \overset{!}{=} \lambda_1 + \lambda_2$$

$$(41b) \quad e^{-s_0 \cdot T} - (r_1 + r_2) \cdot \dfrac{A'}{s_0} \cdot (1 - e^{-s_0 \cdot T}) + r_2 \cdot \dfrac{A'}{s_0} \cdot (1 - e^{-s_0 \cdot T}) \overset{!}{=} \lambda_1 \cdot \lambda_2$$

Die Gleichungen (41a) und (41b) führen zu den Gleichungen (42a) und (42b), anhand derer die Reglerkoeffizienten $r_1$ und $r_2$ des Reglermodells 325a aus den Parametern des äquivalenten diskreten Basisbandmodels und vorgegebenen Eigenwerten ermittelt werden können:

$$(42a) \quad r_1 = \dfrac{e^{-s_0 \cdot T} - \lambda_1 \cdot \lambda_2}{\dfrac{A'}{s_0} \cdot (1 - e^{-s_0 \cdot T})}$$

$$(42b) \quad r_2 = \dfrac{(1 - \lambda_1) \cdot (1 - \lambda_2)}{\dfrac{A'}{s_0} \cdot (1 - e^{-s_0 \cdot T})}$$

Der Verstärkungsfaktor $K_P$ und der Integrierbeiwert $K_I$ der Reglereinheit 220 gemäß der Figur 3A bestimmen sich aus den Reglerkoeffizienten $r_1$ und $r_2$ des Reglermodells 325a der Figur 3D anhand der Gleichungen (43a) und (43b):

$$(43a) \quad K_P = r_1$$

$$(43b) \qquad K_I \cdot T = r_2$$

Gemäß einer Ausführungsform werden die Eigenwerte $\lambda_1$, $\lambda_2$ mit nicht allzu hohen Dynamikanforderungen vorgegeben, so dass der Einschwingvorgang des Basisbandsystems in guter Näherung die Einhüllende des Einschwingvorgangs des äquivalenten Bandpasssystems beschreibt. Dabei gilt die Übertragbarkeit des Basisbandentwurfs in das Bandpassband nur näherungsweise, da durch die Reglertotzeit der Phasenabgleich für das Bandpassbandsystem gegenüber dem Basisbandsystem wie eine zusätzliche Totzeit wirkt, die bei diesem Reglerentwurf unberücksichtigt bleibt. Daher kann bei Vorgabe von Eigenwerten mit zu hohen Dynamikanforderungen das Bandpassbandsystem instabil sein, obwohl das äquivalente Basisbandsystem stabil ist. Jedoch kann durch Heranziehen des Nyquist-Stabilitätskriteriums die Stabilität des Bandpassbandentwurfs für die jeweils vorgegebenen Eigenwerte jederzeit abgeschätzt werden.

Sieht das Verfahren zur Dimensionierung eines Reglers die Eigenwertvorgabe vor, so wird damit auch die Lage der beiden Eigenwerte zueinander vorgegeben. Dagegen kann es bei Dimensionierung des PI-Reglers für harmonische Führungsgrößen durch Pol/Nullstellenkompensation zu einer starken Abweichung der beiden Eigenwerte voneinander kommen, so dass der gekürzte Streckenpol als Eigenwert im geschlossenen Kreis verbleibt und bei der üblicherweise niedrigen Dämpfung des Schwingers zu einer hohen Zeitkonstante führt. Zwar hat der "gekürzte" Eigenwert keinen Einfluss auf das Führungsverhalten, jedoch kann er durch Störungen angeregt werden und lang andauernde Abklingvorgänge zur Folge haben. Im Gegensatz dazu erlaubt ein Entwurf per Eigenwertvorgabe die Vorgabe beider Eigenwerte in etwa der gleichen Größenordnung und damit eine positive Beeinflussung des Störverhaltens. Gemäß einer Ausführungsform werden die beiden Eigenwerte gleich oder näherungsweise gleich mit einer Abweichung von maximal 10% zum größeren Eigenwert gesetzt.

Das folgende Ausführungsbeispiel illustriert die oben beschriebenen Entwurfsverfahren für den PI-Regler 325 für eine Regelstrecke mit folgenden Parametern angewandt:

$$\omega_0 = 2 \cdot \pi \cdot 9000 \text{ Hz}$$

$$s_0 = \frac{\omega_0}{200000}$$

$$A = s_0{}^2 + \omega_0{}^2$$

$$T_S = \frac{\pi}{4 \cdot \omega_0} \qquad \beta_S = \frac{\pi}{4 \cdot \omega_0 \cdot T}$$

$$T = \frac{1}{100000 \text{ Hz}}$$

Da die durch die Streckentotzeit hervorgerufene Phase bei der Resonanzkreisfrequenz $\omega_0$ kleiner als 90° ist, kann ein Phasenanteil von 180° durch einen invertierenden Regler (Minuszeichen im Regler) realisiert werden. Für die Reglertotzeit $\beta_D T$ ergibt sich dann mit Gleichung (24b) die Dimensionierungsvorschrift gemäß Gleichung (44):

$$(44) \qquad \beta_D = \frac{\pi}{4 \cdot \omega_0 \cdot T} - \frac{1}{2} = 0.\overline{888}$$

Nach einem Verfahren, das die Dimensionierung des diskreten PI-Reglers 325 durch Pol/Nullstellenkompensation vorsieht, kann der Verstärkungsfaktor $K_P$ beispielsweise analog zu dem in der Figur 2C gezeigten Beispiel mit $K_P = -1/10$ angesetzt werden. Der Integrierbeiwert $K_I$ ergibt sich dann gemäß Gleichung (32) zu

$$K_I \cdot T = -2.8274 \cdot 10^{-7}.$$

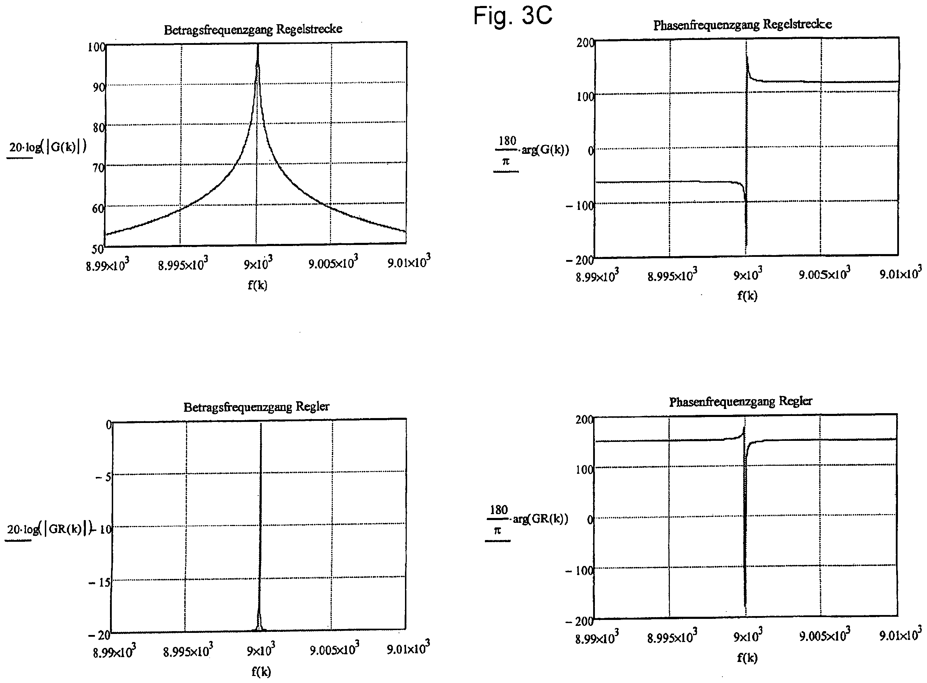

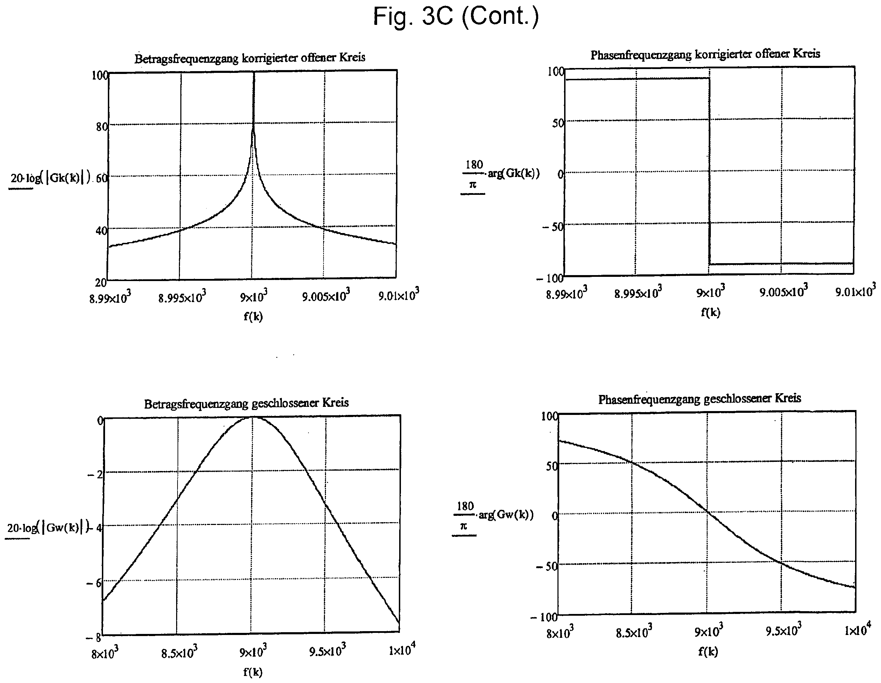

Die Figur 3C zeigt in der linken Spalte von oben nach unten die Betragsfrequenzgänge für Regelstrecke, Regler, korrigierten offenen Kreis und geschlossenen Kreis und in der rechten Spalte die entsprechenden Phasenfrequenzgänge für das berechnete Ausführungsbeispiel. Aus dem Frequenzgang des geschlossenen Kreises lässt sich eine Bandbreite von etwa 500 Hz innerhalb der 3 dB-Grenzen ablesen.

Wird demgegenüber der diskrete PI-Regler 325 per Eigenwertvorgabe dimensioniert, so werden beispielsweise die Eigenwerte gleich groß und betragsmäßig so gewählt, dass der geschlossene Kreis des äquivalenten Basisbandsystems einen doppelten reellen Eigenwert bei $\lambda_1 = \lambda_2 = 0.98$ aufweist. Aus den Gleichungen (42a) und (42b) ergeben sich dann die Reglerkoeffizienten $r_1 = 0.14004655$ und $r_2 = 1.41471261 \cdot 10^{-3}$. Unter Berücksichtigung des für den Phasenabgleich erforderlichen Minuszeichens ergeben sich für den Verstärkungsfaktor $K_P$ und den Integrierbeiwert $K_I$ des diskreten PI-Reglers 325 die Werte $K_P = -0.14004655$ und

$$K_I \cdot T = -1.41471261 \cdot 10^{-3}.$$

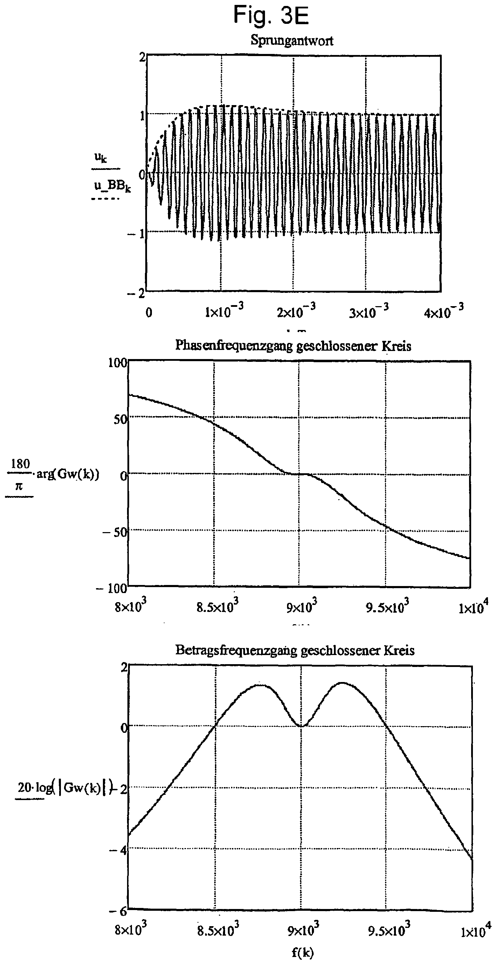

Die Figur 3E zeigt im oberen Diagramm die Sprungantwort des über einen solchen diskreten PI-Reglers geregelten Bandpassbandsystems als durchgezogene Linie sowie die Sprungantwort des äquivalenten Basisbandsystems als gepunktete Line, die näherungsweise dem oberen Ast der Hüllkurve der Sprungantwort des diskreten PI-Reglers entspricht. Unten links ist der Betragsfrequenzgang des geschlossenen Bandpassbandsystems und rechts daneben der entsprechende Phasenfrequenzgang dargestellt, aus denen beispielsweise die Bandbreite des geschlossenen Kreises abgelesen werden kann.

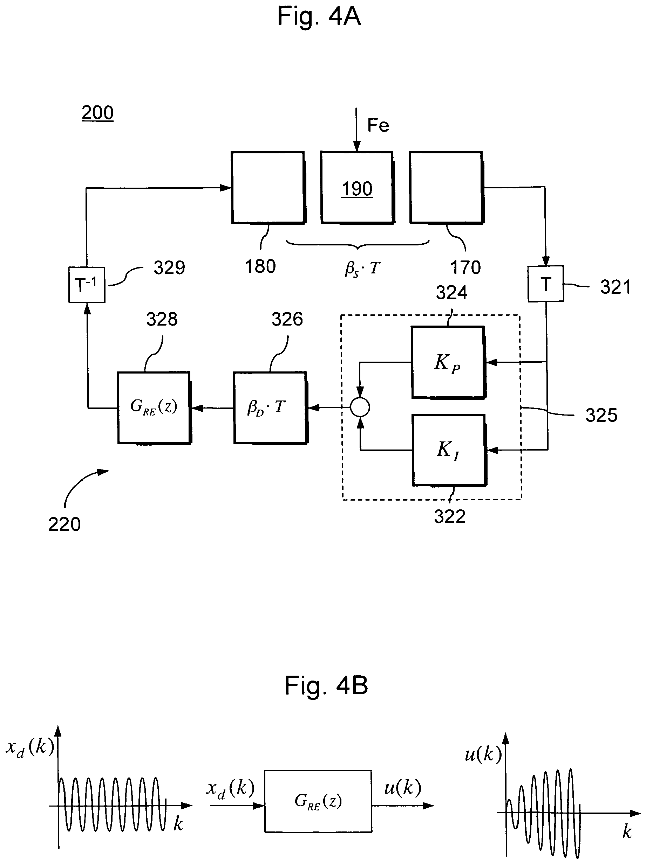

Die Figuren 4A bis 4C beziehen sich auf eine Ausführungsform, bei der die Reglereinheit 320 eine Reglererweiterung 328 aufweist, die in Reihe zu dem PI-Regler 325 und dem Totzeitglied 326 gemäß der Figur 3A angeordnet ist. Im Folgenden wird die Struktur der Reglererweiterung 328 aus einer analogen Reglererweiterung für das Basisband abgeleitet.

Beispielsweise kann der Schwinger 190 neben der Resonanzkreisfrequenz bei $\omega_0$ noch weitere Resonanzen aufweisen, beispielsweise mechanische Strukturresonanzen oberhalb oder unterhalb der Resonanzkreisfrequenz $\omega_0$. Die Reglererweiterung 328 wird so ausgelegt, dass sie diese weiteren Resonanzen stärker bedämpft. Zu diesem Zweck würde im Basisband einem konventionellen PI-Regler ein Verzögerungsglied erster Ordnung (PT$_1$-Glied) mit einem weiteren Pol bei einer Knickfrequenz jenseits der gewünschten Bandbreite hinzufügt werden. Dieser zusätzliche Reglerpol bewirkt, dass der Regler für hohe Frequenzen nicht mehr als Proportionalglied wirkt, sondern dass dessen Betragsfrequenz mit 20 dB/Dekade abfällt. Die Sprungantwort y(k) einer solchen Erweiterung im Basisband ergibt sich aus der Sprungfunktion $\sigma(k)$ als Eingangssignal u(k) nach Gleichung (45):

$$(45) \qquad y(k) = (1 - e^{-\frac{k \cdot T}{T_1}}) \cdot \sigma(k)$$

Die z-Transformierte U(z) des Eingangssignals u(k) entspricht der z-Transformierten des Sprungsignals:

$$(46a) \qquad U(z) = \frac{z}{z-1}$$

Die z-Transformierte Y(z) des Ausgangssignals y(k) ergibt sich nach Gleichung (46b):

$$(46b) \qquad Y(z) = \frac{z}{z-1} - \frac{z}{z - e^{-\frac{T}{T_1}}}$$

Analog der Gleichung (10) ergibt sich demnach für die Übertragungsfunktion $G_{REO}(z)$ einer solchen Reglererweiterung im Basisband:

$$(47) \qquad G_{RE0}(z) = \frac{1 - e^{-\frac{T}{T_1}}}{z - e^{-\frac{T}{T_1}}}$$

Gemäß einer Ausführungsform wird nun in Analogie zur Reglererweiterung im Basisband die Reglererweiterung 328 im Bandpassband so ausgebildet, dass die Reglererweiterung 328 auf eine Beaufschlagung mit einer durch die Sprungfunktion modulierten harmonischen Schwingung der Resonanzkreisfrequenz $\omega_0$ mit einer harmonischen Schwingung der gleichen Frequenz antwortet, wobei die Sprungantwort der Basisbanderweiterung die Hüllkurve vorgibt, wie es auf der rechten Seite der Figur 4B dargestellt ist.

Die Figur 4B zeigt das Transformieren einer sinusmodulierten Sprungfunktion u(k) auf ein Ausgangssignal mit einer Sinusschwingung, dessen Hüllkurve sich aus der Sprungantwort gemäß der Übertragungsfunktion $G_{REO}(z)$ der diskreten Reglererweiterung im Bandpassband ergibt. Das Eingangssignal der Reglererweiterung 328 im Bandpassband mit der Übertragungsfunktion $G_{RE}(z)$ ergibt sich nach Gleichung (48):

$$(48) \qquad u(k) = \sin(\omega_0 \cdot T \cdot k) \cdot \sigma(k)$$

Das Reglerausgangssignal y(k) ist eine harmonische Schwingung, dessen Hüllkurve der Sprungantwort der $PT_1$-Reglererweiterung im Basisband entspricht:

$$(49) \qquad y(k) = (1 - e^{-\frac{k \cdot T}{T_1}}) \cdot \sin(\omega_0 \cdot T \cdot k) \cdot \sigma(k)$$

Die z-Transformierten U(z) und Y(z) ergeben sich nach den Gleichungen (50a) und (50b):

$$(50a) \qquad U(z) = \frac{z \cdot \sin(\omega_0 \cdot T)}{z^2 - 2 \cdot \cos(\omega_0 \cdot T) \cdot z + 1}$$

$$(50b) \qquad Y(z) = z \cdot \frac{\sin(\omega_0 \cdot T)}{z^2 - 2 \cdot \cos(\omega_0 \cdot T) \cdot z + 1} - z \cdot \frac{e^{-\frac{T}{T_1}} \cdot \sin(\omega_0 \cdot T)}{z^2 - 2 \cdot e^{-\frac{T}{T_1}} \cdot \cos(\omega_0 \cdot T) \cdot z + e^{-2\frac{T}{T_1}}}$$

Die Übertragungsfunktion $G_{RE}(z)$ der Reglererweiterung 328 für das Bandpassband ergibt sich nach Gleichung (51):

$$(51) \qquad G_{RE}(z) = \frac{Y(z)}{U(z)} = \frac{(1 - e^{-\frac{T}{T_1}}) \cdot z^2 - e^{-\frac{T}{T_1}} \cdot (1 - e^{-\frac{T}{T_1}})}{z^2 - 2 \cdot e^{-\frac{T}{T_1}} \cdot \cos(\omega_0 \cdot T) \cdot z + e^{-2\frac{T}{T_1}}}$$

Die Reglererweiterung 328 mit der Übertragungsfunktion $G_{RE}(z)$ wirkt in Reihe zum diskreten PI-Regler 325 ähnlich einem Bandpass erster Ordnung mit der Resonanzkreisfrequenz $\omega_0$ als Mittenfrequenz. Betrag und Phase des korrigierten offenen Kreises bei der Resonanzkreisfrequenz $\omega_0$ in einem schmalen Bereich um die Resonanzkreisfrequenz $\omega_0$ gemäß Gleichung (52) bleiben unverändert.

$$(52) \qquad \omega_0 - \frac{1}{T_1} \leq \omega \leq \omega_0 + \frac{1}{T_1}$$

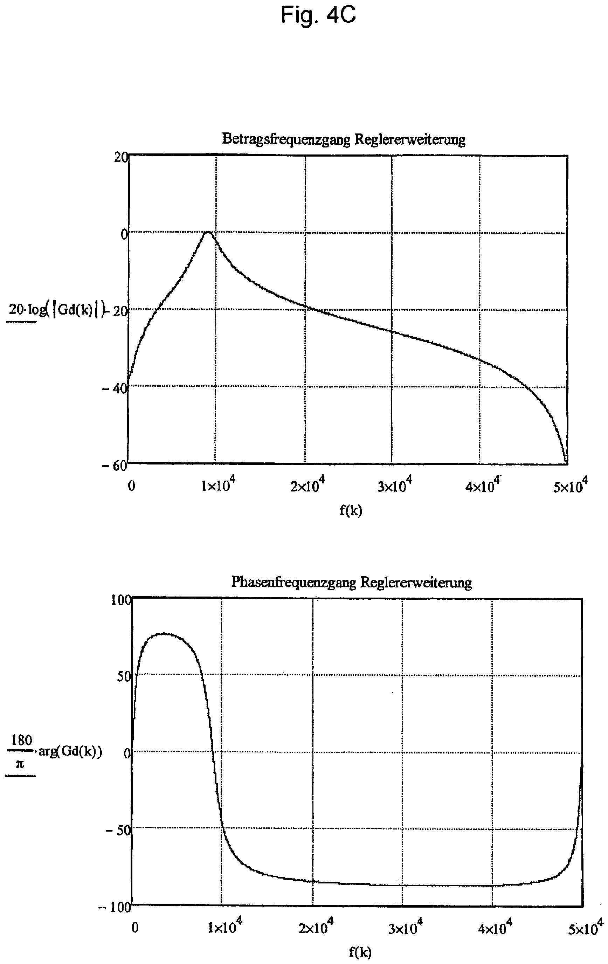

In diesem Bereich wird der Betragsfrequenzgang des korrigierten offenen Kreises kaum beeinflusst, während außerhalb dieses Bereichs eine deutliche Betragsabsenkung stattfindet, so dass mögliche unerwünschte Resonanzen abgesenkt werden können. Die Figur 4C zeigt den Betragsfrequenzgang sowie den Phasenfrequenzgang für die Reglererweiterung für $T_1 = 1/(2 \cdot \pi \cdot 1000\ Hz)$ mit einer Übertragungsfunktion $G_{RE}(z)$ nach Gleichung (51).

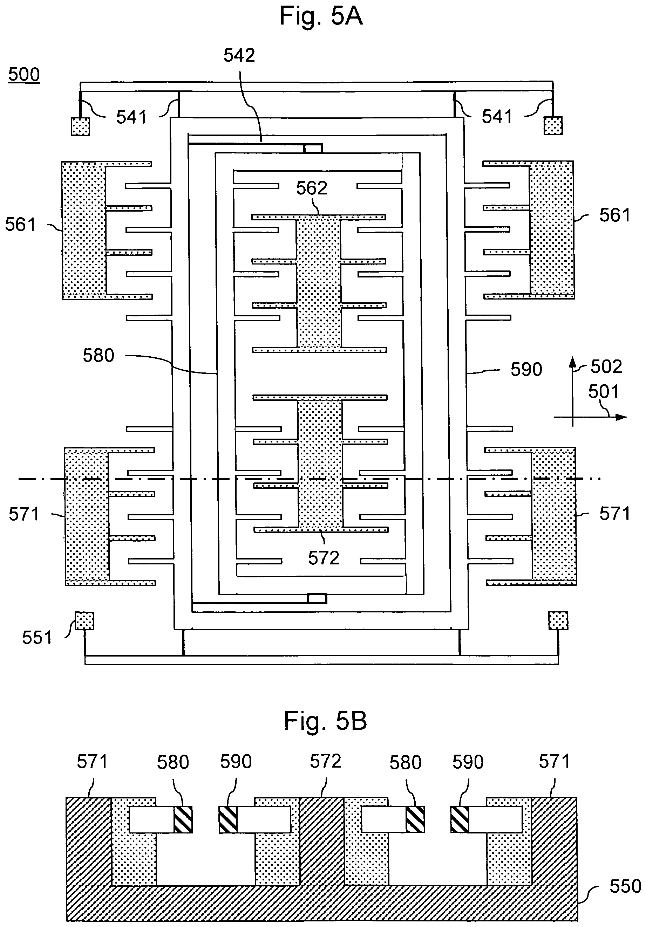

Die Figuren 5A bis 5C beziehen sich auf einen mikromechanischen Drehratensensor 500 gemäß einer weiteren Ausführungsform. Der Drehratensensor 500 umfasst eine an ersten Federelementen 541 aufgehängte Anregungseinheit 590, z.B einen Anregungsrahmen. Die ersten Federelemente 541 koppeln die Anregungseinheit 590 an eine Aufhängestruktur 551, die fest mit einem in der Figur 5B dargestellten Trägersubstrat 550 verbunden ist. Die Federelemente 541 dämpfen eine Auslenkung der Anregungseinheit 590 gegenüber dem Trägersubstrat 550 entlang der Anregungsrichtung 501 nur schwach. Uber zweite Federelemente 542 ist eine Detektionseinheit 580 an die Anregungseinheit 590 gekoppelt und gegenüber der Anregungseinheit 590 hauptsächlich entlang einer zur Anregungsrichtung 501 orthogonalen Detektionsrichtung 502 beweglich. Anregungs- und Detektionsrichtung 501, 502 verlaufen parallel zu einer Oberfläche des Trägersubstrats 550. Die ersten und zweiten Federelemente 541, 542 sind beispielsweise balkenähnliche Strukturen mit kleinem Querschnitt, die zwischen den jeweils zu koppelnden Strukturen ausgebildet sind.

Gemäß einer Ausführungsform umfasst der Drehratensensor 500 erste Kraftgeber- und Sensoreinheiten 561, 571, z.B. elektrostatische Kraftgeber und Sensoren, die das aus der Anregungseinheit 590 und der Detektionseinheit 580 gebildete System zu einer Schwingung entlang der Anregungsrichtung 501 anregen und/oder eine entsprechende Auslenkung der Anregungseinheit 590 zu erfassen vermögen. Der Drehratensensor 500 umfasst ferner zweite Kraftgeber- und Sensoreinheiten 562, 572 z.B. elektrostatische Kraftgeber und Sensoren, die auf die Detektionseinheit 580 einzuwirken und/oder deren Auslenkung zu erfassen vermögen. Nach einer Ausführungsform wird mindestens eine der zweiten Kraftgeber- und Sensoreinheiten 562, 572 derart angesteuert, dass sie einer durch eine Störgröße oder, im Falle von closed-loop Systemen, einer durch die Messgröße bewirkten Auslenkung der Detektionseinheit 580 entgegenwirkt.

Im Betrieb des Drehratensensors 500 regen beispielsweise die ersten Kraftgeber- und Sensoreinheiten 561, 571 die Anregungseinheit 590 zu einer Schwingung entlang der Anregungsrichtung 501 an, wobei sich die Detektionseinheit 580 näherungsweise mit derselben Amplitude und Phase mit der Anregungseinheit 590 mitbewegt. Wird die Anordnung um eine zur Substratebene orthogonale Achse gedreht, so wirkt auf die Anregungseinheit 590 und die Detektionseinheit 580 eine Corioliskraft, die die Detektionseinheit 580 relativ zur Anregungseinheit 590 in die Detektionsrichtung 502 auslenkt. Die zweiten Kraftgeber- und Sensoreinheiten 562, 572 erfassen die Auslenkung der Detektionseinheit 580 und damit die Drehbewegung um die zur Substratebene orthogonale Achse.

Gemäß einer Ausführungsform wirkt mindestens eine der Kraftgeber- und Sensoreinheiten 561, 571, 562, 572 als Aktuator und entweder die Anregungseinheit 590 oder die Detektionseinheit 580 als Schwinger im Sinne einer der im Vorhergehenden beschriebenen Vorrichtungen 200.

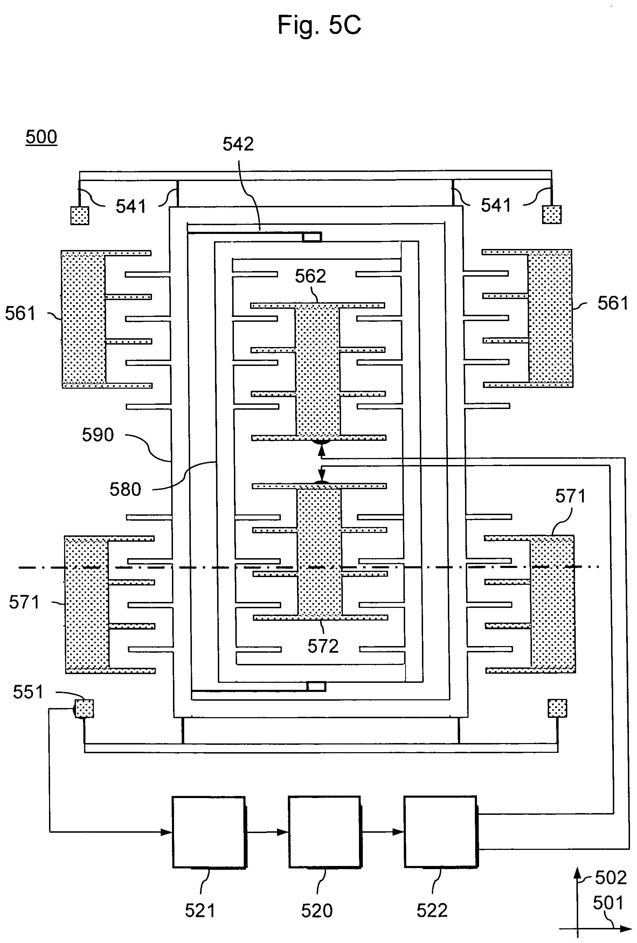

Gemäß einer in der Figur 5C dargestellten Ausführungsform des Drehratensensors 500 regen beispielsweise die ersten Kraftgeber- und Sensoreinheiten 561, 571 die Anregungseinheit 590 zu einer Schwingung mit der Resonanzkreisfrequenz $\omega_0$ entlang der Anregungsrichtung 501 an. In einem Regelkreis der oben besprochenen Art kann dann beispielsweise eine Schwingung der Detektionseinheit 580 entlang der Detektionsrichtung 502 (x2-Schwinger) dem harmonischen Kraftsignal wie oben beschrieben entsprechen.

Die Auslenkung des x2-Schwingers kann über die Ladung auf der gemeinsamen beweglichen Elektrode erfasst werden, die auf der Anregungseinheit 590 ausgebildet ist. Die Ladung kann über eine der Aufhängestrukturen 551 abgegriffen werden. Eine Ladungsverstärkungseinheit 521 verstärkt das abgegriffene Signal. Während üblicherweise eine Demodulatoreinheit das abgegriffene Signal mit einer Frequenz, die beispielsweise der Resonanzkreisfrequenz $\omega_0$ entspricht, demoduliert, bevor es einer Reglereinheit zugeführt wird, sehen es die Ausführungsformen der Erfindung vor, einer Reglereinheit 520 der oben besprochenen Art das nicht demodulierte, harmonische Signal als Messsignal im obigen Sinne zuzuführen.

Die für die Schwingung wirksame Dämpfung $s_0$ ist wesentlich kleiner als die Resonanzkreisfrequenz $\omega_0$. Das über den Anregungsrahmen bzw. die Anregungseinheit 590 abgegriffene Signal bildet teilweise die Bewegung der Anregungseinheit 590 entlang der Anregungsrichtung 501 mit ab. Eine Störgröße, deren Quelle außerhalb des Drehratensensors 500 liegen kann, bzw. , in einem closed-loop System, die Messgröße, überlagert sich der Schwingung und moduliert deren Amplitude. Die Reglereinheit 520 leitet aus dem modulierten, harmonischen Signal ein Steuersignal für die zweiten Kraftgeber- und Sensoreinheiten 562, 572 ab, das bewirkt, dass diese der durch die Störgröße bzw. durch die Messgröße bewirkten Auslenkung entgegenwirken. Eine Verstärkereinheit 522 wandelt das Steuersignal in ein geeignetes Rückstellsignal für die Elektroden der zweiten Kraftgeber- und Sensoreinheiten 562, 572 um. Die Reglereinheit 520 ist entsprechend einer der oben beschriebenen Reglereinheiten 220 ausgebildet und dimensioniert. Bildet die Amplitudenmodulation des harmonischen Signals die Messgröße ab, kann eine Demodulatoreinheit vorgesehen sein, die durch Demodulation des harmonischen Steuersignals mit der Resonanzkreisfrequenz $\omega_0$, das Drehratensignal erzeugt.

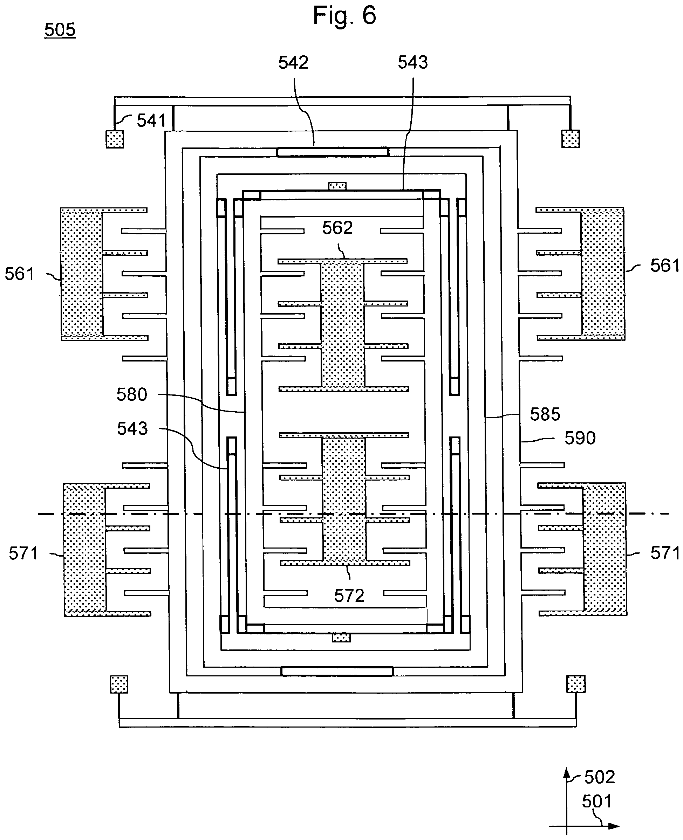

Der in der Figur 6 dargestellte Drehratensensor 505 unterscheidet sich von dem in der Figur 5A dargestellten Drehratensensor 500 durch eine zwischen der Anregungseinheit 590 und der Detektionseinheit 580 angeordnete Corioliseinheit 585. Zweite Federelemente 542, die die Corrioliseinheit 585 an die Anregungseinheit 590 koppeln, lassen eine Auslenkung der Corioliseinheit 585 relativ zur Anregungseinheit 590 in der Detektionsrichtung 502 zu. Dritte Federelemente 543, die teilweise mit dem Trägersubstrat 550 verbunden sein können, koppeln die Detektionseinheit 580 derart an die Corioliseinheit 585, dass die Detektionseinheit 580 der Bewegung der Corioliseinheit 585 entlang der Detektionsrichtung 502, nicht aber entlang der Anregungsrichtung 501 folgen kann. Die Detektionseinheit 580 ist bezüglich der Anregungsrichtung 501 fixiert und in der Detektionsrichtung 502 beweglich.

Gemäß anderen Ausführungsformen wirkt mindestens eine der ersten oder zweiten Kraftgeber- und Sensoreinheiten 561, 562, 571, 572 als Aktuator, und entweder die Anregungseinheit 590 oder die Detektionseinheit 580 oder sowohl die Anregungsseinheit 590 und die Detektionseinheit 580 als Schwinger im Sinne einer der im Vorhergehenden beschriebenen Vorrichtungen, die nach dem beschriebenen Prinzip des Bandpassreglers betrieben. Dabei wirken die Kraftgeber- und Sensoreinheiten 561 und 571 als Kraftgeber- bzw. Sensoreinheit für den xl-Schwinger und die Kraftgeber- und Sensoreinheiten 562 und 572 als Kraftgeber- bzw. Sensoreinheiten für den x2-Schwinger.

Ein Drehratensensor gemäß einer anderen Ausführungsform umfasst zwei der in der Figur 5A oder in der Figur 6 dargestellten Anordnungen, die untereinander derart gekoppelt sind, dass die Anregungseinheiten im stationären Zustand einander entgegengesetzte Schwingungen ausführen. Andere Ausführungsformen betreffen Drehratensensoren mit vier der in der Figur 5A oder in der Figur 6 dargestellten Anordnungen, die untereinander derart gekoppelt sind, dass jeweils zwei der Anregungseinheiten im stationären Zustand einander entgegengesetzte Schwingungen ausführen.

Eine weitere Ausführungsform bezieht sich auf die in den Figuren 2A, 3A und 4A dargestellte Reglereinheit 220. Die Reglereinheit 220 umfasst mindestens einen PI-Regler 225, 325 für harmonische Führungsgrößen, der seinerseits ein proportionales Übertragungsglied 224, 324 und ein zum proportionalen Übertragungsglied 224, 324 parallel angeordnetes integrierendes Übertragungsglied 222, 322 aufweist, wobei ein Reglereingang der Reglereinheit 220 mit beiden Übertragungsgliedern 222, 224, 322, 324 verbunden ist. Die Übertragungsfunktion des PI-Reglers 225, 325 für harmonische Führungsgrößen weist einen konjugiert komplexen Pol bei einer Reglerkreisfrequenz $\omega_r$ in der s-Ebene oder bei $e^{\pm j\omega_r T}$ in der z-Ebene auf, wobei T die Abtastzeit eines diskreten Eingangssignals des PI-Reglers 325 und $\omega_r$ größer 0 ist.

Dazu sind ein Integrierbeiwert des integrierenden Übertragungsglieds 222, 322 und ein Verstärkungsfaktor des proportionalen Übertragungsglieds 224, 324 so gewählt, dass der PI-Regler 225, 325 für harmonische Führungsgrößen bei Beaufschlagung mit einem durch die Sprungfunktion modulierten harmonischen Eingangssignal der Reglerkreisfrequenz $\omega_r$ am Reglereingang zur Erzeugung einer harmonische Schwingung der Reglerkreisfrequenz $\omega_r$ mit steigender Amplitude an einem Reglerausgang geeignet ist.

Der PI-Regler 225, 325 für harmonische Führungsgrößen kann als ein vom konventionellen PI-Regler für stationäre Führungsgrößen abgeleiteter Regler aufgefasst werden und unterscheidet sich von diesem durch die Lage der Pole in der s-bzw. z-Ebene.

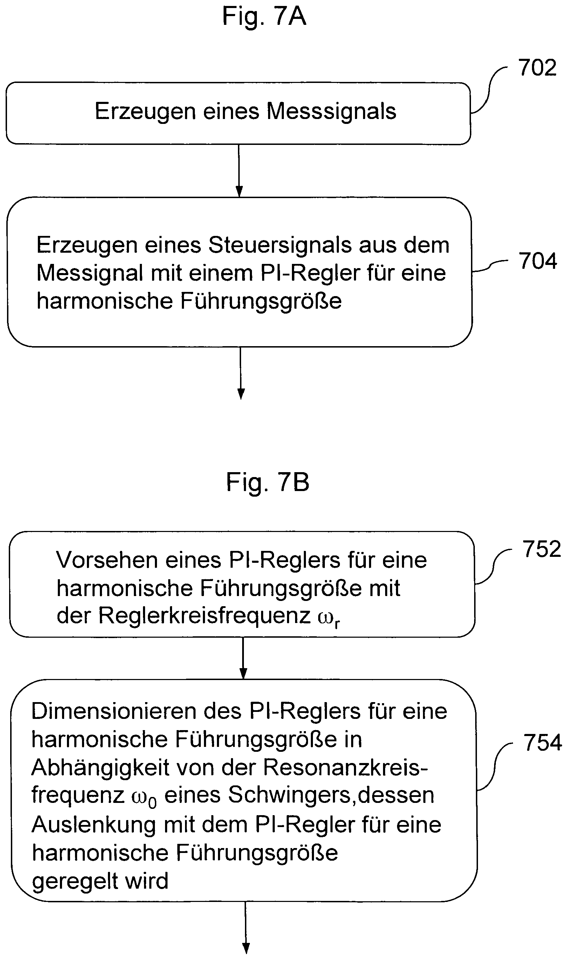

Die Figur 7A bezieht sich auf ein Verfahren zum Betrieb eines Drehratensensors. Im Betrieb eines Drehratensensors erzeugt ein Sensor ein Messsignal, das eine Auslenkung eines Schwingers abbildet (702). Aus dem Messsignal erzeugt eine Reglereinheit ein Steuersignal für einen Aktuator, der der Abweichung der Auslenkung des Schwingers von einer harmonischen Schwingung mit einer Resonanzkreisfrequenz $\omega_0$ entgegenwirkt (704). Die Reglereinheit weist dazu einen PI-Regler mit einem proportionalen Übertragungsglied und einem zum proportionalen Übertragungsglied parallel angeordneten integrierenden Übertragungsglied auf, wobei ein Reglereingang der Reglereinheit mit beiden Übertragungsgliedern verbunden ist. Die Übertragungsfunktion des PI-Reglers weist einen konjugiert komplexen Pol bei einer Resonanzkreisfrequenz $\omega_0$ des Schwingers in der s-Ebene oder einen Pol bei $e^{\pm j\omega_0 T}$ in der z-Ebene auf. Dabei ist T die Abtastzeit eines diskreten Eingangssignals des PI-Reglers und $\omega_0$ ist größer 0.

Die Figur 7B bezieht sich auf Verfahren zur Herstellung eines Drehratensensors. Das Verfahren umfasst das Dimensionieren einer Reglereinheit mit einem PI-Regler mit einem proportionalen Übertragungsglied und einem zum proportionalen Übertragungsglied parallel angeordneten integrierenden Übertragungsglied, wobei ein Reglereingang der Reglereinheit mit beiden Übertragungsgliedern verbunden ist. Der PI-Regler wird mit einer Übertragungsfunktion vorgesehen (752), die einen konjugiert komplexen Pol bei einer Reglerkreisfrequenz $\omega_r$ in der s-Ebene oder einen Pol bei $e^{\pm j\omega_r T}$ in der z-Ebene aufweist, wobei T die Abtastzeit eines diskreten Eingangssignals des PI-Reglers und $\omega_r$ größer 0 ist. Die Reglerkreisfrequenz $\omega_r$ wird dabei so gewählt, dass die Reglerkreisfrequenz $\omega_r$ gleich der Resonanzkreisfrequenz $\omega_0$ eines Schwingers des Drehratensensors ist (754). Dazu werden ein Integrierbeiwert des integrierenden Übertragungslieds und ein Verstärkungsfaktor des proportionalen Übertragungsglieds so gewählt, dass der PI-Regler bei Beaufschlagung mit einem durch die Sprungfunktion modulierten harmonischen Eingangssignal der Resonanzkreisfrequenz $\omega_0$ am Reglereingang zur Erzeugung einer harmonische Schwingung der Resonanzkreisfrequenz $\omega_0$ mit steigender Amplitude an einem Reglerausgang geeignet ist.

**Patentansprüche**

1. Ein Drehratensensor umfassend
   einen beweglichen Schwinger (190), der in einer Anregungsrichtung zu einer Schwingung mit einer Resonanzkreisfrequenz $\omega_0$ anregbar ist, und
   eine Reglereinheit (220) umfassend einen PI-Regler (225, 325) mit einem proportionalen Übertragungsglied (224, 324) und einem zum proportionalen Übertragungsglied (224, 324) parallel angeordneten integrierenden Übertragungsglied (222, 322), wobei ein Reglereingang der Reglereinheit (220) mit beiden Übertragungsgliedern (222, 224, 322, 324) verbunden ist, **dadurch gekennzeichnet,**

**dass** eine Übertragungsfunktion des PI-Reglers (225, 325) einen konjugiert komplexen Pol bei einer Reglerkreisfrequenz $\omega_0$ in der s-Ebene oder einen Pol bei $e^{\pm j\omega_0 T}$ in der z-Ebene aufweist, wobei T die Abtastzeit eines diskreten Eingangssignals des PI-Reglers (225, 325) und $\omega_0$ größer 0 ist.

2.  Der Drehratensensor nach Anspruch 1, wobei
    ein Integrierbeiwert des integrierenden Übertragungslieds (222, 322) und ein Verstärkungsfaktor des proportionalen Übertragungsglieds (224, 324) so gewählt sind, dass der PI-Regler (225, 325) bei Beaufschlagung mit einem durch die Sprungfunktion modulierten harmonischen Eingangssignal der Reglerkreisfrequenz $\omega_0$ am Reglereingang zur Erzeugung einer harmonische Schwingung der Reglerkreisfrequenz $\omega_0$ mit steigender Amplitude an einem Reglerausgang geeignet ist.

3.  Der Drehratensensor nach Anspruch 1 oder 2, wobei
    der Integrierbeiwert und der Verstärkungsfaktor so gewählt sind, dass die Nullstellen der Übertragungsfunktion des PI-Reglers (225, 325) Pole einer Übertragungsfunktion des Schwingers (190) kompensieren.

4.  Der Drehratensensor nach einem der Ansprüche 1 bis 3, wobei
    der PI-Regler ein kontinuierlicher PI-Regler (225) ist und
    das Verhältnis von Integrierbeiwert zu Verstärkungsfaktor gleich einer Dämpfung $s_0$ des Schwingers (190) in der Anregungsrichtung ist.

5.  Der Drehratensensor nach Anspruch 4, wobei
    eine den Schwinger (190) umfassende Regelstrecke eine Streckentotzeit $T_s$ aufweist,
    die Reglereinheit (220) in Serie zum PI-Regler (225) ein Totzeitglied (226) mit einer Reglertotzeit $T_R$ umfasst, und entweder
    der PI-Regler (225) ein invertierender Regler und das Produkt aus der Resonanzkreisfrequenz $\omega_0$ und der Summe aus Streckentotzeit $T_S$ und Reglertotzeit $T_R$ gleich $\pi/2$ oder
    der PI-Regler (225) ein nicht-invertierender Regler und das Produkt aus der Resonanzkreisfrequenz $\omega_0$ und der Summe aus Streckentotzeit $T_S$ und Reglertotzeit $T_R$ gleich $3\pi/2$ ist.

6.  Der Drehratensensor nach einem der Ansprüche 1 bis 3, wobei
    der PI-Regler ein diskreter PI-Regler (325) ist, der mit einem aus einer Abtastung mit der Abtastzeit T hervorgegangenen diskreten Eingangssignal beaufschlagbar ist,
    der Schwinger (190) in der Anregungsrichtung eine Dämpfung $s_0$ aufweist, und
    das Verhältnis von Integrierbeiwert zu Verstärkungsfaktor gleich dem Verhältnis $s_0 : (1-s_0 \cdot T)$ ist.

7.  Der Drehratensensor nach einem der Ansprüche 1 bis 3, wobei
    der PI-Regler ein diskreter PI-Regler (325) ist, der mit einem aus einer Abtastung mit der Abtastzeit T hervorgegangenen diskreten Eingangssignal beaufschlagbar ist,
    der Integrierbeiwert und der Verstärkungsfaktor so gewählt sind, dass die Übertragungsfunktion des geschlossenen Kreises eines äquivalenten Basisbandsystems einen doppelten reellen Eigenwert aufweist.

8.  Der Drehratensensor nach einem der Ansprüche 6 oder 7, wobei
    eine den Schwinger (190, 590) umfassende Regelstrecke eine Streckentotzeit $\beta_s \cdot T$ aufweist,
    die Reglereinheit (220) in Serie zum diskreten PI-Regler (325) ein Totzeitglied (326) mit einer Reglertotzeit $\beta_D \cdot T$ umfasst, und entweder
    der diskrete PI-Regler (325) ein invertierender Regler und das Produkt aus der Resonanzkreisfrequenz $\omega_0$ und der Summe aus Streckentotzeit $\beta_s \cdot T$, Reglertotzeit $\beta_D \cdot T$ und der halben Abtastzeit $T/2$ gleich $\pi/2$ oder
    der diskrete PI-Regler (325) ein nicht-invertierender Regler und das Produkt aus der Resonanzkreisfrequenz $\omega_0$ und der Summe aus Streckentotzeit $\beta_s \cdot T$, Reglertotzeit $\beta_D \cdot T$ und der halben Abtastzeit $T/2$ gleich $3\pi/2$ ist.

9.  Der Drehratensensor nach einem der Ansprüche 1 bis 8, **gekennzeichnet durch**
    eine in Reihe zum PI-Regler (225, 325) angeordnete Reglererweiterung (328), die als Bandpass mit einer Mittenfrequenz bei der Resonanzkreisfrequenz $\omega_0$ wirkt.

10. Der Drehratensensor nach Anspruch 9, wobei
    eine Übertragungsfunktion $G_{RE}(z)$ der Reglererweiterung (328) mit einer Bandpassbreite $1/T_1$ durch folgende Gleichung bestimmt ist:

$$G_{RE}(z) = \frac{(1-e^{-\frac{T}{T_1}}) \cdot z^2 - e^{-\frac{T}{T_1}} \cdot (1-e^{-\frac{T}{T_1}})}{z^2 - 2 \cdot e^{-\frac{T}{T_1}} \cdot \cos(\omega_0 \cdot T) \cdot z + e^{-2\frac{T}{T_1}}}$$

11. Der Drehratensensor nach einem der Ansprüche 1 bis 10, wobei
die Vorrichtung ein Drehratensensor (500, 505) und der Schwinger eine Anregungseinheit (590), eine Corioliseinheit (585) oder eine Detektionseinheit (580) des Drehratensensors (500, 505) ist, wobei
die Anregungseinheit (590) durch einen Kraftgeber (561) entlang einer Anregungsrichtung auslenkbar und zu einer Schwingung mit der Resonanzkreisfrequenz $\omega_0$ geeignet ist,
die Corioliseinheit (585) an der Anregungseinheit (590) derart befestigt ist, dass die Corioliseinheit (585) einer Bewegung der Anregungseinheit (590) entlang der Anregungsrichtung folgt und zusätzlich entlang einer zur Anregungsrichtung senkrechten Detektionsrichtung beweglich ist, und
die Detektionseinheit (580) derart an der Anregungseinheit (590) oder an der Corioliseinheit (585) befestigt ist, dass die Detektionseinheit (580) entweder

einer Bewegung der Anregungseinheit (590) entlang der Anregungsrichtung folgt und zusätzlich entlang einer zur Anregungsrichtung senkrechten Detektionsrichtung beweglich ist, oder
einer Bewegung der Corioliseinheit (585) entlang einer zur Anregungsrichtung senkrechten Detektionsrichtung folgt und entlang der Anregungsrichtung fixiert ist.

12. Ein Verfahren zum Betrieb eines Drehratensensors, umfassend
Erzeugen eines eine Auslenkung eines Schwingers (190) abbildenden Messsignals mittels eines Sensors (170), und Erzeugen eines Steuersignals für einen Aktuator (180) aus dem Messsignal, wobei der Aktuator (180) der Abweichung des Schwingers (190) von einer harmonischen Schwingung mit einer Resonanzkreisfrequenz $\omega_0$ entgegenwirkt, das Steuersignal mittels einer Reglereinheit (220) aus dem Messsignal abgeleitet wird, und die Reglereinheit (220) einen PI-Regler (225, 325) mit einem proportionalen Übertragungsglied (224, 324) und einem zum proportionalen Übertragungsglied (224, 324) parallel angeordneten integrierenden Übertragungsglied (222, 322) umfasst, wobei ein Reglereingang der Reglereinheit (220) mit beiden Übertragungsgliedern (222, 224, 322, 324) verbunden ist, **dadurch gekennzeichnet dass** eine Übertragungsfunktion des PI-Reglers (225, 325) einen konjugiert komplexen Pol bei der Resonanzkreisfrequenz $\omega_0$ in der s-Ebene oder einen Pol bei $e^{\pm j\omega_0 T}$ in der z-Ebene aufweist, wobei T die Abtastzeit eines diskreten Eingangssignals des PI-Reglers (225, 325).

13. Ein Verfahren zur Herstellung eines Drehratensensors, umfassend
Dimensionieren einer Reglereinheit (220) umfassend einen PI-Regler (225, 325) mit einem proportionalen Übertragungsglied (224, 324) und einem zum proportionalen Übertragungsglied (224, 324) parallel angeordneten integrierenden Übertragungsglied (222, 322), wobei ein Reglereingang der Reglereinheit (220) mit beiden Übertragungsgliedern (222, 224, 322, 324) verbunden ist, wobei der PI-Regler (225, 325) mit einer Übertragungsfunktion vorgesehen wird, die einen konjugiert komplexen Pol bei einer Reglerkreisfrequenz $\omega_r$ in der s-Ebene oder einen Pol bei $e^{\pm j\omega_r T}$ in der z-Ebene aufweist, wobei T die Abtastzeit eines diskreten Eingangssignals des PI-Reglers (225, 325) und $\omega_r$ größer 0 ist und ein Integrierbeiwert des integrierenden Übertragungslieds (222, 322) und ein Verstärkungsfaktor des proportionalen Übertragungsglieds (224, 324) so gewählt werden, dass der PI-Regler (225, 325) bei Beaufschlagung mit einem durch die Sprungfunktion modulierten harmonischen Eingangsignal der Reglerkreisfrequenz $\omega_r$ am Reglereingang zur Erzeugung einer harmonische Schwingung der Reglerkreisfrequenz $\omega_r$ mit steigender Amplitude an einem Reglerausgang geeignet ist, und
die Reglerkreisfrequenz $\omega_r$ so gewählt wird, dass die Reglerkreisfrequenz $\omega_r$ gleich der Resonanzkreisfrequenz $\omega_0$ einer Anregungseinheit (590) des Drehratensensors ist.

14. Das Verfahren nach Anspruch 13, wobei
der Integrierbeiwert und der Verstärkungsfaktor so gewählt werden, dass Nullstellen der Übertragungsfunktion des PI-Reglers (225, 325) Pole der Übertragungsfunktion der Anregungseinheit (590) kompensieren.

15. Das Verfahren nach Anspruch 13, wobei
der PI-Regler ein diskreter PI-Regler (325) ist, der mit einem aus einer Abtastung mit der Abtastzeit T hervorgegangenen diskreten Eingangssignal beaufschlagbar ist, und
der Integrierbeiwert und der Verstärkungsfaktor so gewählt sind, dass die Übertragungsfunktion des geschlossenen Kreises eines äquivalenten Basisbandsystems einen doppelten reellen Eigenwert aufweist.

**Claims**

1.  A rotation rate sensor comprising
    a moveable oscillator (190) which is excitable in a direction of excitation to an oscillation with a resonance angular frequency $\omega_0$, and
    a controller unit (220) comprising a PI-controller (225, 325) with a proportional transfer element (224, 324) and an integrating transfer element (222, 322), arranged parallel to the proportional transfer element (224, 324), wherein a controller input of the controller unit (220) is connected with both transfer elements (222, 224, 322, 324), **characterized in**
    **that** a transfer function of the PI-controller (225, 325) has a conjugate complex pole at a controller angular frequency $\omega_0$ in the s-plane or a pole at $e^{\pm j\omega_0 T}$ in the z-plane, wherein T is the sampling time of a discrete input signal of the PI-controller (225, 325) and $\omega_0$ is larger than 0.

2.  The rotation rate sensor unit according to claim 1, wherein
    an integral action coefficient of the integrating transfer element (222, 322) and an amplification factor of the proportional transfer element (224, 324) are chosen such that the PI-controller (225, 325) is suitable for generating, at admission with a harmonic input signal of the controller angular frequency $\omega_0$ modulated by the step function at the controller input, a harmonic oscillation of the controller angular frequency $\omega_0$ with rising amplitude at the controller output.

3.  The rotation rate sensor according to claim 1 or 2, wherein
    the integral action coefficient and the amplification factor are chosen such that the zeros of the transfer function of the PI-controller (225, 325) compensate poles of a transfer function of the oscillator (190).

4.  The rotation rate sensor according to any one of claims 1 to 3, wherein
    the PI-controller is a continuous PI-controller (225) and
    the ratio of integral action coefficient to amplification factor is equal to a damping $s_0$ of the oscillator (190) in the direction of excitation.

5.  The rotation rate sensor according to claim 4, wherein
    a controlled system comprising the oscillator (190) has a system dead time $T_S$,
    the controller unit (220) comprises in series to the PI-controller (225) a dead time element (226) with a controller dead time $T_R$, and either
    the PI-controller (225) is an inverting controller and the product of the resonance angular frequency $\omega_0$ and the sum of the system dead time $T_S$ and the controller dead time $T_R$ is equal to $\pi/2$ or
    the PI-controller (225) is a non-inverting controller and the product of the resonance angular frequency $\omega_0$ and the sum of the system dead time $T_S$ and the controller dead time $T_R$ is equal to $3\pi/2$.

6.  The rotation rate sensor according to any one of claims 1 to 3, wherein
    the PI-controller is a discrete PI-controller (325), on which a discrete input signal can be impinged that emerges from a sampling with the sampling time T,
    the oscillator (190) has a damping $s_0$ in the direction of excitation, and
    the ratio of the integral action coefficient to the amplification factor equals the ratio $s_0 : (1-s_0 \cdot T)$.

7.  The rotation rate sensor according to any one of claims 1 to 3, wherein
    the PI-controller is a discrete PI-controller (325), on which a discrete input signal can be impinged that emerges from a sampling with the sampling time T,
    the integral action coefficient and the amplification factor are chosen such that the transfer function of the closed loop of an equivalent baseband system has a double real eigenvalue.

8.  The rotation rate sensor according to any one of claims 6 or 7, wherein
    a controlled system comprising the oscillator (190, 590) has a system dead time $\beta_S \cdot T$,
    the controller unit (220) comprises a dead time element (326) with a controller dead time $\beta_D \cdot T$ in series to the discrete PI-controller (325), and either
    the discrete PI-controller (325) is an inverting controller and the product from the resonance angular frequency $\omega_0$ and the sum of the system dead time $\beta_S \cdot T$, controller dead time $\beta_D \cdot T$, and the half sampling time T/2 is equal to $\pi/2$ or
    the discrete PI-controller (325) is a non-inverting controller and the product of the resonance angular frequency $\omega_0$ and the sum of the system dead time $\beta_S \cdot T$, the controller dead time $\beta_D \cdot T$, and the half sampling time T/2 is equal to $3\pi/2$.

9. The rotation rate sensor according to any one of claims 1 to 8, **characterized by**
a controller extension (328), arranged in series to the PI-controller (225, 325), which acts as bandpass with a midband frequency at the resonance angular frequency $\omega_0$.

10. The rotation rate sensor according to claim 9, wherein
a transfer function $G_{RE}(z)$ of the controller extension (328) with a bandwidth $1/T_1$ is determined by the following equation:

$$G_{RE}(z) = \frac{(1-e^{-\frac{T}{T_1}}) \cdot z^2 - e^{-\frac{T}{T_1}} \cdot (1-e^{-\frac{T}{T_1}})}{z^2 - 2 \cdot e^{-\frac{T}{T_1}} \cdot \cos(\omega_0 \cdot T) \cdot z + e^{-2\frac{T}{T_1}}}$$

11. The rotation rate sensor according to any one of claims 1 to 10, wherein
the device is a rotation rate sensor (500, 505) and the oscillator is an excitation unit (590), a Coriolis unit (585) or a detection unit (580) of the rotation rate sensor (500, 505), wherein
the excitation unit (590) is deflectable by a force transmitter (561) along a direction of excitation and is suitable for an oscillation with the resonance angular frequency $\omega_0$,
the Coriolis unit (585) is attached to the excitation unit (590) such that the Coriolis unit (585) follows a movement of the excitation unit (590) along the direction of excitation and that the Coriolis unit (585) is additionally moveable along a detection direction orthogonal to the direction of excitation, and
the detection unit (580) is attached such to the excitation unit (590) or to the Coriolis unit (585) that the detection unit (580) either

follows a movement of the excitation unit (590) along the direction of excitation and is additionally moveable along a detection direction orthogonal to the direction of excitation, or
follows a movement of the Coriolis unit (585) along a detection direction orthogonal to the direction of excitation and is fixed along the direction of excitation.

12. A method for operating a rotation rate sensor, comprising
generating a measurement signal by a sensor (170) reproducing a deflection of an oscillator (190), and
generating a controller signal for an actuator (180) from the measurement signal, wherein the actuator (180) counteracts the deviation of the oscillator (190) from a harmonic oscillation with the resonance angular frequency $\omega_0$,
the controller signal is deduced by means of a controller unit (220) from the measurement signal, and the controller unit (220) comprises a PI-controller (225, 325) with a proportional transfer element (224, 324) and an integrating transfer element (222, 322), arranged parallel to the proportional transfer element (224, 324), wherein a controller input of the controller unit (220) is connected with both transfer elements (222, 224, 322, 324),
**characterized in that**
a transfer function of the PI-controller (225, 325) has a conjugate complex pole at the resonance angular frequency $\omega_0$ in the s-plane or a pole at $e^{\pm j\omega_0 T}$ in the z-plane, wherein T is the sampling time of a discrete input signal of the PI-controller (225, 325).

13. A method for manufacturing a rotation rate sensor, comprising
dimensioning a controller unit (220) comprising a PI-controller (225, 325) with a proportional transfer element (224, 324) and an integrating transfer element (222, 322), arranged parallel to the proportional transfer element (224, 324), wherein a controller input of the controller unit (220) is connected with both transfer elements (222, 224, 322, 324), wherein
the PI-controller (225, 325) is provided with a transfer function that has a conjugate complex pole at a controller angular frequency $\omega_r$ in the s-plane or a pole at $e^{\pm j\omega_r T}$ in the z-plane, wherein T is the sampling time of a discrete input signal of the PI-controller (225, 325) and $\omega_r$ is larger than 0 and an integral action coefficient of the integrating transfer element (222, 322) and an amplification factor of the proportional transfer element (224, 324) are chosen such that the PI-controller (225, 325) is suitable for generating, at admission with a harmonic input signal of controller angular frequency $\omega_r$ modulated by the step function at the controller input, a harmonic oscillation of the controller angular frequency $\omega_r$ with rising amplitude at the controller output, and
the controller angular frequency $\omega_r$ is chosen such that the controller angular frequency $\omega_r$ is equal to the resonance angular frequency $\omega_0$ of an excitation unit (590) of the rotation rate sensor.

**14.** The method according to claim 13, wherein
the integral action coefficient and the amplification factor are chosen such that the zeros of the transfer functions of the PI-controller (225, 325) compensate the poles of the transfer functions of the excitation unit (590).

**15.** The method according to claim 13, wherein
the PI-controller is a discrete PI-controller (325), on which a discrete input signal can be impinged that emerges from a sampling with the sampling time T, and
the integral action coefficient and the amplification factor are chosen such that the transfer function of the closed loop of an equivalent baseband system has a double real eigenvalue.

**Revendications**

**1.** Capteur de vitesse de rotation comprenant
un oscillateur (190) mobile, qui peut être excité dans une direction d'excitation pour produire une oscillation avec une fréquence de résonance $\omega_0$, et
une unité de régulateur (220) comprenant un régulateur proportionnel et intégral (225, 325) avec un organe de transmission proportionnel (224, 324) et un organe de transmission d'intégration (222, 322) disposé de manière parallèle à l'organe de transmission proportionnel (224, 324), dans lequel une entrée de régulateur de l'unité de régulateur (220) est reliée aux deux organes de transmission (222, 224, 322, 324), **caractérisé en ce qu'**une fonction de transmission du régulateur proportionnel et intégral (225, 325) présente un pôle à conjugaison complexe à une fréquence de résonance $\omega_0$ dans le plan s ou un pôle à $e^{\pm/\omega_0 T}$ dans le plan z, dans lequel T est la durée de balayage d'un signal d'entrée discret du régulateur proportionnel et intégral (225, 325) et $\omega_0$ est supérieure à 0.

**2.** Capteur de vitesse de rotation selon la revendication 1, dans lequel
un coefficient d'intégration de l'organe de transmission d'intégration (222, 322) et un facteur d'amplification de l'organe de transmission proportionnel (224, 324) sont choisis de telle sorte que le régulateur proportionnel et intégral (225, 325) est adapté lorsqu'il est soumis à l'action d'un signal d'entrée harmonique de la fréquence de régulateur $\omega 0$ modulé par une fonction de saut sur l'entrée de régulateur pour générer une oscillation harmonique de la fréquence de régulateur $\omega_0$ avec une amplitude croissante sur une sortie de régulateur.

**3.** Capteur de vitesse de rotation selon la revendication 1 ou 2, dans lequel
le coefficient d'intégration et le facteur d'amplification sont choisis de telle sorte que les zéros de la fonction de transmission de régulateur proportionnel et intégral (225, 325) compensent des pôles d'une fonction de transmission de l'oscillateur (190).

**4.** Capteur de vitesse de rotation selon l'une des revendications 1 à 3, dans lequel
le régulateur proportionnel et intégral est un régulateur proportionnel et intégral (225) continu, et
le rapport entre le coefficient d'intégration et le facteur d'amplification est égal à un amortissement $s_0$ de l'oscillateur (190) dans la direction d'excitation.

**5.** Capteur de vitesse de rotation selon la revendication 4, dans lequel
un système réglé comprenant l'oscillateur (190) présente une durée système $T_s$,
l'unité de régulateur (220) comprend en série par rapport au régulateur proportionnel et intégral (225) un élément à retard (226) avec une durée régulateur $T_R$, et soit
le régulateur proportionnel et intégral (225) est un régulateur d'inversion et le produit de la fréquence de résonance $\omega_0$ et de la somme de la durée système $T_s$ et de la durée régulateur $T_R$ est égal à $\pi/2$ soit
le régulateur proportionnel et intégral (225) est un régulateur sans inversion et le produit de la fréquence de résonance $\omega_0$ et de la somme de la durée système $T_S$ et de la durée régulateur $T_R$ est égal à 3n/2.

**6.** Capteur de vitesse de rotation selon l'une des revendications 1 à 3, dans lequel
le régulateur proportionnel et intégral est un régulateur proportionnel et intégral discret (325), qui peut être soumis à l'action d'un signal d'entrée discret provenant d'un balayage avec la durée de balayage T,
l'oscillateur (190) présente dans la direction d'excitation un amortissement $s_0$,
et
le rapport entre le coefficient d'intégration et le facteur d'amplification est égal au rapport $s_0 : (1-s_0. T)$ .

**7.** Capteur de vitesse de rotation selon l'une des revendications 1 à 3, dans lequel

le régulateur proportionnel et intégral est un régulateur proportionnel et intégral discret (325), qui peut être soumis à l'action d'un signal d'entrée discret provenant d'un balayage avec la durée de balayage T,

le coefficient d'intégration et le facteur d'amplification sont choisis de telle sorte que la fonction de transmission du circuit fermé d'un système à bande de base équivalent présente une double valeur propre réelle.

**8.** Capteur de vitesse de rotation selon l'une des revendications 6 ou 7, dans lequel

un système réglé comprenant l'oscillateur (190, 590) présente une durée système $\beta_s.T$,

l'unité de régulateur (220) comprend en série par rapport au régulateur proportionnel et intégral discret (325) un élément à retard (326) avec une durée régulateur $\beta_D.T$, et soit

le régulateur proportionnel et intégral discret (325) est un régulateur d'inversion et le produit de la fréquence de résonance $\omega_0$ et de la somme de la durée système $\beta_s.T$, de la durée régulateur $\beta_D.T$ et de la moitié de la durée de balayage T/2 est égal à n/2, soit

le régulateur proportionnel et intégral discret (325) est un régulateur sans inversion et le produit de la fréquence de résonance $\omega_0$ et de la somme de la durée système $\beta_S.T$, de la durée régulateur $\beta_D.T$ et de la moitié de la durée de balayage T/2 est égal à 3n/2.

**9.** Capteur de vitesse de rotation selon l'une des revendications 1 à 8, **caractérisé par**

un élargissement de régulateur (328) disposé en série avec le régulateur proportionnel et intégré (225, 325) qui agit en tant que filtre passe-bande avec une fréquence moyenne pour la fréquence de résonance $\omega_0$.

**10.** Capteur de vitesse de rotation selon la revendication 9, dans lequel

une fonction de transmission $G_{RE}(z)$ de l'élargissement de régulateur (328) est définie par une largeur de filtre passe-bande $1/T_1$ par l'équation suivante :

$$G_{RE}(z) = \frac{(1-e^{-\frac{T}{T_1}}) \cdot z^2 - e^{-\frac{T}{T_1}} \cdot (1-e^{-\frac{T}{T_1}})}{z^2 - 2 \cdot e^{-\frac{T}{T_1}} \cdot \cos(\omega_0 \cdot T) \cdot z + e^{-2\frac{T}{T_1}}}$$

**11.** Capteur de vitesse de rotation selon l'une des revendications 1 à 10, dans lequel

le dispositif est un capteur de vitesse de rotation (500, 505) et l'oscillateur est une unité d'excitation (590), une unité de Coriolis (585) ou une unité de détection (580) du capteur de vitesse de rotation (500, 505), dans lequel

l'unité d'excitation (590) peut être déviée par un générateur de force (561) le long d'une direction d'excitation et est adaptée aux fins d'une oscillation avec la fréquence de résonance $\omega_0$,

l'unité de Coriolis (585) est fixée à l'unité d'excitation (590) de telle manière que l'unité de Coriolis (585) suit un mouvement de l'unité d'excitation (590) le long de la direction d'excitation et est mobile en supplément le long d'une direction de détection perpendiculaire à la direction d'excitation, et

l'unité de détection (580) est fixée de telle manière à l'unité d'excitation (590) ou à l'unité de Coriolis (585) que l'unité de détection (580) soit

suit un mouvement de l'unité d'excitation (590) le long de la direction d'excitation et est mobile en supplément le long d'une direction de détection perpendiculaire à la direction d'excitation, soit

suit un mouvement de l'unité de Coriolis (585) le long d'une direction de détection perpendiculaire à la direction d'excitation et est bloquée le long de la direction d'excitation.

**12.** Procédé pour faire fonctionner un capteur de vitesse de rotation, comprenant

la génération d'un signal de mesure reproduisant une déviation d'un oscillateur (190) au moyen d'un capteur (170), et

la génération d'un signal de commande pour un actionneur (180) à partir du signal de mesure, dans lequel l'actionneur (180) contrecarre l'écart de l'oscillateur (190) par rapport à une oscillation harmonique avec une fréquence de résonance $\omega_0$, le signal de commande est dérivé du signal de mesure au moyen d'une unité de régulateur (220), et l'unité de régulateur (220) comprend un régulateur proportionnel et intégral (225, 325) avec un organe de transmission proportionnel (224, 324) et un organe de transmission d'intégration (222, 322) disposé de manière parallèle à l'organe de transmission proportionnel (224, 324), dans lequel une entrée de régulateur de l'unité de régulateur (220) est reliée aux deux organes de transmission (222, 224, 322, 324), **caractérisé en ce que**

une fonction de transmission du régulateur proportionnel et intégral (225, 325) présente un pôle à conjugaison complexe à une fréquence de résonance $\omega_0$ dans le plan s ou un pôle à $e^{\pm/\omega_0 T}$ dans le plan z, dans lequel T est la durée de balayage d'un signal d'entrée discret du régulateur proportionnel et intégral (225, 325) .

13. Procédé de fabrication d'un capteur de vitesse de rotation, comprenant
le dimensionnement d'une unité de régulateur (220) comprenant un régulateur proportionnel et intégral (225, 325) avec un organe de transmission proportionnel (224, 324) et un organe de transmission d'intégration (222, 322) disposé de manière parallèle à l'organe de transmission proportionnel (224, 324), dans lequel une entrée de régulateur de l'unité de régulateur (220) est reliée aux deux organes de transmission (222, 224, 322, 324), dans lequel le régulateur proportionnel et intégral (225, 325) est prévu avec une fonction de transmission, qui présente un pôle à conjugaison complexe à une fréquence de régulateur $\omega_r$ dans le plan s ou un pôle à $e^{\pm j\omega T}$ dans le plan z, dans lequel T est la durée de balayage d'un signal d'entrée discret du régulateur proportionnel et intégral (225, 325) et $\omega_r$ est supérieure à 0 et un coefficient d'intégration de l'organe de transmission d'intégration (222, 322) et un facteur d'amplification de l'organe de transmission proportionnel (224, 324) sont choisis de telle sorte que le régulateur proportionnel et intégral (225, 325) est adapté lorsqu'il est soumis à l'action d'un signal d'entrée harmonique de la fréquence de régulateur $\omega_r$ modulé par la fonction de saut sur l'entrée de régulateur pour générer une oscillation harmonique de la fréquence de régulateur $\omega_r$ avec une amplitude croissante sur une sortie de régulateur, et
la fréquence de régulateur $\omega_r$ est choisie de telle sorte que la fréquence de régulateur $\omega_r$ est égale à la fréquence de résonance $\omega_0$ d'une unité d'excitation (590) du capteur de vitesse de rotation.

14. Procédé selon la revendication 13, dans lequel
le coefficient d'intégration et le facteur d'amplification sont choisis de telle sorte que des zéros de la fonction de transmission du régulateur proportionnel et intégral (225, 325) compensent des pôles d'une fonction de transmission de l'unité d'excitation (590).

15. Procédé selon la revendication 13, dans lequel
le régulateur proportionnel et intégral est un régulateur proportionnel et intégral discret (395), qui peut être soumis à l'action d'un signal d'entrée discret provenant d'un balayage avec la durée de balayage T, et
le coefficient d'intégration et le facteur d'amplification sont choisis de telle sorte que la fonction de transmission du circuit fermé d'un système à bande de base équivalent présente une double valeur propre réelle.

## Fig. 1A
## Stand der Technik

## Fig. 1B
## Stand der Technik

Fig. 1C
Stand der Technik

Fig. 1D

Betragsfrequenzgang Regler

$\frac{20 \cdot \log(|GR(k)|)}{}$

Phasenfrequenzgang Regler

$\frac{180}{\pi} \cdot \arg(GR(k))$

Betragsfrequenzgang Regelstrecke

$\frac{\cdot \log(|G(k)|)}{}$

Phasenfrequenzgang Regelstrecke

$\frac{180}{\pi} \cdot \arg(G(k))$

# Fig. 1D (Cont)

Betragsfrequenzgang geschlossener Kreis

$20 \cdot \log(|Gw(k)|)$

f(k)

Betragsfrequenzgang Regler

$20 \cdot \log(|GR(k)|)$

f(k)

Phasenfrequenzgang geschlossener Kreis

$\dfrac{180}{\pi} \cdot \arg(Gw(k))$

f(k)

Phasenfrequenzgang Regler

$\dfrac{180}{\pi} \cdot \arg(GR(k))$

f(k)

EP 2 656 153 B1

## Fig. 2A

Fe

<u>200</u>

<u>190</u>

180

$T_S$

170

224

226

220

$T_R$

$K_P$

225

$K_I$

222

$$\frac{K_I}{K_P} \approx s_0 \qquad vz = sign(K_I)$$

$$(T_S + T_R) \cdot \omega_0 = \frac{3}{2}\pi \quad \text{für} \quad vz = +1$$

$$(T_S + T_R) \cdot \omega_0 = \frac{1}{2}\pi \quad \text{für} \quad vz = -1$$

## Fig. 2B

$x_d(t)$

$t$

$x_d(t)$

$G_{R0}(s)$

$u(t)$

$u(t)$

$t$

# Fig. 2C

# Fig. 2C (Cont.)

Phasenfrequenzgang korrigierter offener Kreis

$$\frac{180}{\pi} \cdot \arg(Gk(k))$$

f(k)

Betragsfrequenzgang korrigierter offener Kreis

$$20 \cdot \log(\left|Gk(k)\right|)$$

f(k)

Phasenfrequenzgang geschlossener Kreis

$$\frac{180}{\pi} \cdot \arg(Gw(k))$$

f(k)

Betragsfrequenzgang geschlossener Kreis

$$20 \cdot \log(\left|Gw(k)\right|)$$

f(k)

32

# Fig. 3A

$$\frac{K_I}{K_P} \approx s_0 \quad vz = sign(K_I)$$

$$\left(\beta_S + \beta_D + \frac{1}{2}\right) \cdot \omega_0 \cdot T = \frac{3}{2}\pi \quad f\ddot{u}r \quad vz = +1$$

$$\left(\beta_S + \beta_D + \frac{1}{2}\right) \cdot \omega_0 \cdot T = \frac{1}{2}\pi \quad f\ddot{u}r \quad vz = -1$$

# Fig. 3B

## Fig. 3C

Betragsfrequenzgang Regelstrecke

$20 \cdot \log(|G(k)|)$

Phasenfrequenzgang Regelstrecke

$\dfrac{180}{\pi} \cdot \arg(G(k))$

Betragsfrequenzgang Regler

$20 \cdot \log(|GR(k)|)$

Phasenfrequenzgang Regler

$\dfrac{180}{\pi} \cdot \arg(GR(k))$

EP 2 656 153 B1

Fig. 3C (Cont.)

# Fig. 3D

# Fig. 3E

**Sprungantwort**

$$\frac{u_k}{u\_BB_k}$$
- - - -

**Phasenfrequenzgang geschlossener Kreis**

$$\frac{180}{\pi} \cdot \arg(Gw(k))$$

**Betragsfrequenzgang geschlossener Kreis**

$$20 \cdot \log(|Gw(k)|)$$

f(k)

# Fig. 4A

<u>200</u>

Fe

<u>190</u>

$\beta_S \cdot T$

180    170

329  $T^{-1}$    321  T

328  $G_{RE}(z)$    326  $\beta_D \cdot T$    324  $K_P$

325

322  $K_I$

220

# Fig. 4B

$x_d(k)$

$k$

$x_d(k)$ → $G_{RE}(z)$ → $u(k)$

$u(k)$

$k$

# Fig. 4C

Betragsfrequenzgang Reglererweiterung

$20 \cdot \log\left(|Gd(k)|\right)$

f(k)

Phasenfrequenzgang Reglererweiterung

$\dfrac{180}{\pi} \cdot \arg(Gd(k))$

f(k)

# Fig. 5A

# Fig. 5B

# Fig. 5C

# Fig. 6

## Fig. 7A

702

Erzeugen eines Messsignals

704

Erzeugen eines Steuersignals aus dem Messignal mit einem PI-Regler für eine harmonische Führungsgröße

## Fig. 7B

752

Vorsehen eines PI-Reglers für eine harmonische Führungsgröße mit der Reglerkreisfrequenz $\omega_r$

754

Dimensionieren des PI-Reglers für eine harmonische Führungsgröße in Abhängigkeit von der Resonanzkreis-frequenz $\omega_0$ eines Schwingers, dessen Auslenkung mit dem PI-Regler für eine harmonische Führungsgröße geregelt wird

**IN DER BESCHREIBUNG AUFGEFÜHRTE DOKUMENTE**

**In der Beschreibung aufgeführte Patentdokumente**

- WO 9315447 A1
- DE 102008044000 A1